# EUROPÄISCHE PATENTANMELDUNG

(11) **EP 4 660 348 A2**
(43) Veröffentlichungstag der Anmeldung: **10.12.2025**
(21) Anmeldenummer: 25174520.4
(22) Anmeldetag: 06.05.2025
(51) Int. Cl.: C23C 14/50, C23C 16/458

(54) **SUBSTRATTRÄGER, SUBSTRATTRÄGER-HALTEVORRICHTUNG, VAKUUMANORDNUNG, VERWENDUNG UND VERFAHREN**

(30) Priorität: 14.05.2024 DE 102024113390
(71) Anmelder: VON ARDENNE Asset GmbH & Co. KG, 01328 Sachsen Dresden (DE)
(72) Erfinder: Aulhorn, Stephan, 01445 Dresden (DE); Winkler, Torsten, 01454 Radeberg (DE); Hentschel, Michael, 01157 Dresden (DE); Grosche, Ruben, 01067 Dresden (DE)

(57) **Zusammenfassung**

Gemäß verschiedenen Ausführungsformen weist ein Substratträger-Segment (150) auf: ein Trägergestell (102), eine Substrathaltevorrichtung (106) zum Halten eines Substrats, welche zumindest teilweise in das Trägergestell (102) integriert oder daran montiert ist; eine an das Trägergestell (102) angrenzende Montagevorrichtung (104) zum Montieren des Substratträger-Segments, zu welcher hin sich das Trägergestell (102) verjüngt; zwei Formschlusskonturen (502a, 502b), welche komplementär zueinander eingerichtet sind und zwischen denen eine der Montagevorrichtung (104) gegenüberliegende Außenseite des Trägergestells (102) angeordnet ist.

## Beschreibung

Verschiedene Ausführungsbeispiele betreffen einen Substratträger, eine Substratträger-Haltevorrichtung, eine Vakuumanordnung, ein Verwendung und ein Verfahren.

Im Allgemeinen kann ein Substrat in einem Vakuum behandelt (prozessiert), z.B. beschichtet werden, so dass die chemischen und/oder physikalischen Eigenschaften des Substrats verändert werden können. Zum Beschichten eines Substrats können verschiedene Beschichtungsverfahren durchgeführt werden, wovon die physikalische Gasphasenabscheidung (PVD) ein etablierter Vertreter ist. Beispielsweise kann eine Vakuumbeschichtungsanlage genutzt werden, um eine Schicht oder mehrere Schichten mittels einer chemischen und/oder physikalischen Gasphasenabscheidung auf einem Substrat oder auf mehreren Substraten abzuscheiden. Eine solche Vakuumbeschichtungsanlage kann beispielsweise vom Typ der sogenannten Drehtelleranlage oder vom Typ der sogenannten Durchlaufanlage sein.

Die Drehtelleranlage weist einen tellerförmigen Substratträger (auch als Drehteller bezeichnet) auf, welcher mehrere Substrate trägt und in eine Drehbewegung versetzt wird, so dass die Substrate entlang eines kreisförmigen Transportpfads transportiert werden. Die Drehtelleranlage stellt anschaulich eine kompakte Alternative dar im Vergleich zu der Durchlaufanlage, bei welcher der Transport des Substrats entlang eines geraden Transportpfads durch die gesamte Vakuumbeschichtungsanlage hindurch erfolgt, was viel Bauraum beansprucht.

Für verschiedene Anwendungen bestehen hohe Anforderungen an das Resultat des Beschichtungsprozesses, welcher in einer solchen Drehtelleranlage durchgeführt werden kann. Hierbei greifen verschiedene konstruktive und prozessuale Parameter ineinander, welche das Resultat des Beschichtungsprozesses beeinflussen können.

Gemäß verschiedenen Ausführungsformen werden ein Substratträger, eine Substratträger-Haltevorrichtung, eine Vakuumanordnung, eine Verwendung und ein Verfahren bereitgestellt, welche es erleichtern, hohen Anforderungen an das Resultat des Beschichtungsprozesses (auch als Prozessanforderungen bezeichnet) zu genügen. Beispielsweise wird es erleichtert, die Varianz der Substratposition zu verringern, beispielsweise relativ zu einer Beschichtungsvorrichtung.

Anschaulich wurde erkannt, dass die räumliche Position (d.h. Ort und/oder Ausrichtung) des Substrats (auch als Substratposition bezeichnet), in welcher das Substrat in der Vakuumkammer transportiert wird, mit zunehmenden Prozessanforderungen an Bedeutung gewinnt als Prozessparameter des Beschichtungsprozesses. Diese Lage beeinflusst unter anderem den Abstand des Substrats von der Beschichtungsvorrichtung und somit, wie das Substrat dem Beschichtungsmaterial ausgesetzt wird.

In diesem Zusammenhang wurde erkannt, dass diese Substratposition eine Funktion der Präzession ist, mit welcher der Substratträger, mittels welchem das Substrat beim Transport getragen wird, montiert und eingerichtet werden kann. Allerdings bieten herkömmliche Substratträger kaum Spielraum, um diese Präzision zu verbessern.

Beispielsweise weist ein Substratträger häufig mehrere Segmente (auch als Substratträger-Segment bezeichnet) auf, welche einzeln mit Substraten beladen und montiert werden können (dann auch als mehrteiliger Substratträger bezeichnet). Die zusammengesetzten Substratträger-Segmente bilden dann beispielsweise eine ringförmige Struktur, in deren Mittelpunkt die Drehachse des Substratträgers angeordnet ist, wovon jedes Substratträger-Segment ein oder mehr als ein Substrat halten kann.

Vor diesem Hintergrund werden verschiedene ausführungsformen bereitgestellt, welche das Bereitstellen (z.B. die Herstellung und/oder Montage) eines präzise eingerichteten Substratträgers erleichtern. Beispielsweise wird die Präzision, mit welcher jedes Substratträger-Segment montiert wird, verbessert. Beispielsweise wird die Präzision, mit welcher jedes Substratträger-Segment gefertigt wird, verbessert. Dies mindert Varianzen, z.B. Fertigungsabweichungen und/oder Montageabweichungen, welche sich störend auf die Substratposition auswirken.

Im Folgenden werden verschiedene Beispiele beschrieben, die sich auf vorangehend Beschriebene und in den Figuren Dargestellte beziehen.

Beispiel 1 ist eingerichtet gemäß einem der beigefügten Ansprüche.

Beispiel 2 ist ein Substratträger-Segment (vorzugsweise eingerichtet gemäß Beispiel 1), aufweisend: ein Trägergestell; eine Substrathaltevorrichtung zum Halten eines Substrats, welche zumindest teilweise in das Trägergestell integriert oder daran montiert ist; eine an das Trägergestell angrenzende Montagevorrichtung zum Montieren des Substratträger-Segments, zu welcher hin sich das Trägergestell verjüngt; zwei Formschlusskonturen (auch als Stützkonturen bezeichnet), welche komplementär zueinander eingerichtet sind und zwischen denen eine der Montagevorrichtung gegenüberliegende Außenseite des Trägergestells angeordnet ist.

Beispiel 3 ist eingerichtet gemäß einem der Beispiele 1 bis 2, wobei das Trägergestell zwei einander gegenüberliegende Stirnseiten aufweist, welche derart zueinander eingerichtet (z.B. schräg zueinander) sind, dass sich das Trägergestell verjüngt zu der Montagevorrichtung hin.

Beispiel 4 ist eingerichtet gemäß einem der Beispiele 1 bis 3, wobei jede der Formschlusskonturen an einer der Stirnseiten bereitgestellt ist.

Beispiel 5 ist ein Substratträger-Segment (vorzugsweise gemäß einem der Beispiele 1 bis 4), aufweisend: zwei einander gegenüberliegende Stirnseiten, welche derart zueinander eingerichtet (z.B. schräg zueinander aufweisende Ränder) sind, dass sich das Substratträger-Segment verjüngt zu einer Drehachse hin; eine der Drehachse zugewandte Montagevorrichtung zum Montieren des Substratträger-Segments; eine Substrathaltevorrichtung, welche eingerichtet ist zum Halten eines Substrats und welche zwischen den zwei Stirnseiten angeordnet ist; zwei Formschlusskonturen, welche komplementär zueinander eingerichtet sind und wovon jede Formschlusskontur an einer der Stirnseiten bereitgestellt ist.

Beispiel 6 ist eingerichtet gemäß einem der Beispiele 1 bis 5, wobei die zwei Formschlusskonturen eine erste Formschlusskontur aufweisen, welche vorzugsweise auf einer ersten Stirnseite der zwei Stirnseiten angeordnet ist und/oder einen Vorsprung aufweist; wobei die zwei Formschlusskonturen eine zweite Formschlusskontur aufweisen, welche vorzugsweise auf einer zweiten Stirnseite der zwei Stirnseiten angeordnet ist und/oder eine zu dem Vorsprung komplementäre Aussparung aufweist.

Beispiel 7 ist eingerichtet gemäß einem der Beispiele 1 bis 6, wobei ein Ganzzahliges eines Winkels, in dem die zwei Stirnseiten zueinander verlaufen und/oder in dem sich das Trägergestell verjüngt, ungefähr 360 Grad ergibt.

Beispiel 8 ist eingerichtet gemäß einem der Beispiele 1 bis 7, wobei die zwei Formschlusskonturen (z.B. Stirnseiten mittels ihrer Formschlusskontur) zum Ineinandergreifen eingerichtet sind.

Beispiel 9 ist eingerichtet gemäß einem der Beispiele 1 bis 8, wobei die zwei Formschlusskonturen (z.B. Stirnseiten mittels ihrer Formschlusskontur) zum Zentrieren eingerichtet sind.

Beispiel 10 ist eingerichtet gemäß einem der Beispiele 1 bis 9, wobei die Formschlusskonturen zum Implementieren einer Nut-Zapfen-Verbindung eingerichtet sind.

Beispiel 11 ist eingerichtet gemäß einem der Beispiele 1 bis 10, wobei eine oder mehr als eine der Formschlusskonturen zumindest abschnittsweise keilförmig ist.

Beispiel 12 ist eingerichtet gemäß einem der Beispiele 1 bis 11, wobei eine erste Formschlusskontur der zwei Formschlusskonturen mittels eines Vorsprungs bereitgestellt ist, der vorzugsweise (zumindest abschnittsweise) keilförmig und/oder stufenförmig ist, und wobei die erste Formschlusskontur vorzugsweise mittels einer zapfenförmigen Steckvorrichtung bereitgestellt ist, welche einen keilförmigen Abschnitt des Vorsprungs fortsetzt und/oder der zweiten Formschlusskontur der zwei Formschlusskonturen abgewandt ist.

Beispiel 13 ist eingerichtet gemäß einem der Beispiele 1 bis 12, wobei die Substrathaltevorrichtung eingerichtet ist, zwei Substrate übereinander zu halten, z.B. in einem Abstand voneinander.

Beispiel 14 ist eingerichtet gemäß einem der Beispiele 1 bis 13, wobei die Substrathaltevorrichtung eingerichtet ist, eine oder mehr als eine Substrat formschlüssig aufzunehmen.

Beispiel 15 ist eingerichtet gemäß einem der Beispiele 1 bis 14, ferner aufweisend: ein Bearbeitungsmuster, gemäß welchem das Substratträger-Segment (z.B. eine Oberfläche davon und/oder eine Kante davon) bearbeitet (z.B. getrennt und/oder aufgeraut) ist, wobei das Bearbeitungsmuster symmetrisch ist, vorzugsweise zu einer Achse (z.B. Symmetrieachse des Substratträgers), welche von der Montagevorrichtung weg erstreckt ist.

Beispiel 16 ist eingerichtet gemäß einem der Beispiele 1 bis 15, ferner eine Walzrichtung aufweisend, welche parallel oder quer zu einer Symmetrieachse des Substratträger-Segments ist und/oder welche parallel oder quer ist zu einer Achse (z.B. Symmetrieachse des Substratträgers), welche von der Montagevorrichtung weg erstreckt ist.

Beispiel 17 ist eingerichtet gemäß einem der Beispiele 1 bis 16, ferner aufweisend: die Außenseite aufweisend, welcher der Montagevorrichtung abgewandt ist, eine oder mehr als eine (z.B. gangförmige) Aussparung (auch als Kupplungsaussparung oder Handlertasche bezeichnet) an der Außenseite (z.B. zu der Montagevorrichtung hin und/oder in das Gestell hinein erstreckt), wovon jede Aussparung vorzugsweise: abgewinkelt ist in ein Richtung zu einer der zwei Formschlusskonturen (oder zumindest Stirnseiten) hin; einen sich zu der Montagevorrichtung hin verjüngenden Abschnitt aufweist; und/oder von einer mäanderförmigen Formschlusskontur begrenzt wird.

Beispiel 18 ist ein Substratträger, aufweisend mehrere Substratträger-Segmente, wovon jedes Substratträger-Segment gemäß einem der Beispiele 1 bis 17 eingerichtet ist.

Beispiel 19 ist eine Substratträger-Haltevorrichtung, aufweisend: eine Drehachse, mehrere, gemäß einem (zu der Drehachse symmetrischen) Muster (um die Drehachse herum) angeordnete Montagesockel (auch als Montagevorrichtung der Substratträger-Haltevorrichtung bezeichnet), wovon jeder Montagesockel aufweist: eine (z.B. beweglich, drehbar, gelagerte) Aufnahmevorrichtung zum Aufnehmen eines Substratträger-Segments, das vorzugsweise eingerichtet ist gemäß einem der Beispiele 1 bis Beispiel 17; ein erstes Stellglied (auch als Ausrichtungsglied bezeichnet), welches eingerichtet ist (vorzugsweise in Antwort darauf, betätigt zu werden) zum Verändern eines Winkels (auch als Ausrichtungswinkel bezeichnet) zwischen der Drehachse und der Aufnahmevorrichtung; eine optionale Arretierungsvorrichtung, welche eingerichtet ist, das Verändern des Winkels wahlweise zu arretieren oder freizugeben (vorzugsweise in Antwort darauf, betätigt zu werden); ein optionales Drehgelenk, mittels dessen die Aufnahmevorrichtung beweglich gelagert ist.

Beispiel 20 ist eingerichtet gemäß Beispiel 19, ferner aufweisend: eine Lagervorrichtung (auch als Sockellager bezeichnet), mittels welcher die Aufnahmevorrichtung beweglich relativ zu der Drehachse gelagert ist; das Sockellager vorzugsweise ein Drehlager aufweisend.

Beispiel 21 ist eingerichtet gemäß Beispiel 19 oder 20, wobei das erste Stellglied eingerichtet ist, ein Drehmoment auf die Aufnahmevorrichtung zu übertragen zum Verändern des Winkels und/oder ein Getriebe (z.B. mittels eines Gewindes bereitgestellt) aufweist zum Übertragen des Drehmoment.

Beispiel 22 ist eingerichtet gemäß Beispiel 19 oder 21, wobei die Aufnahmevorrichtung zwei relativ zueinander beweglich gelagerte Spannbacken aufweist, zwischen denen ein Aufnahmespalt gebildet ist und/oder mittels des ersten Stellglieds gehalten wird.

Beispiel 23 ist eingerichtet gemäß Beispiel 22, wobei die Aufnahmevorrichtung eine Feder aufweist zum Bereitstellen einer Rückstellkraft, welche zwischen den Spannbacken vermittelt wird, vorzugsweise diese auseinandertreibend.

Beispiel 24 ist eingerichtet gemäß Beispiel 22 oder 23, wobei die Aufnahmevorrichtung einen oder mehr als einen Vorsprung aufweist zum Begrenzen eines Bewegungspfads beim Aufnehmen des Substratträger-Segments, wobei vorzugsweise das zweite Stellglied zumindest teilweise zwischen zwei Vorsprüngen der Aufnahmevorrichtung angeordnet ist und/oder wovon vorzugsweise jeder Vorsprung einen drehbar gelagerten Ring aufweist.

Beispiel 25 ist eingerichtet gemäß einem der Beispiele 22 bis 24, wobei die Montagevorrichtung ein zweites Stellglied aufweist zum Übertragen einer Kraft in den Aufnahmebereich hinein und/oder zum Vermitteln der Kraft zwischen die Spannbacken, vorzugsweise zum Klemmen der Montagevorrichtung.

Beispiel 26 ist eingerichtet gemäß Beispiel 25, wobei das zweite Stellglied ein Getriebe (z.B. mittels eines Gewindes bereitgestellt) aufweist welche die Spannbacken miteinander kuppelt.

Beispiel 27 ist eine Vakuumanordnung, aufweisend: eine Vakuumkammer, eine Substratträger-Haltevorrichtung gemäß einem der Beispiele 23 bis 26, welche in der Vakuumkammer angeordnet ist.

Beispiel 28 ist eingerichtet gemäß Beispiel 27, ferner eine Beschichtungsvorrichtung aufweisend, welche eingerichtet ist, ein Beschichtungsmaterial zu emittieren, dem die Substratträger-Haltevorrichtung vorzugsweise ausgesetzt ist.

Beispiel 29 ist eingerichtet gemäß Beispiel 27 oder 28, mehrere Substratträger-Segmente, vorzugsweise eingerichtet gemäß einem der Beispiele 1 bis Beispiel 17, mittels des Substratträger-Haltevorrichtung gehalten werden.

Beispiel 30 ist ein Verwenden eines thermischen Prozesses (z.B. Ablationsprozesses und/oder Bestrahlungsprozesses) zum Bilden (z.B. Herstellen) eines Substratträger-Segments (vorzugsweise eingerichtet gemäß einem der Beispiele 1 bis Beispiel 17), welcher gemäß einem Prozessmuster durchgeführt wird, das symmetrisch ist zu einer Symmetrieachse des Substratträger-Segments und/oder zu einem Winkel, in dem zwei einander gegenüberliegende Stirnseiten des Substratträger-Segments zueinander verlaufen.

Beispiel 31 ist eingerichtet gemäß Beispiel 30, wobei der thermische Prozess mittels eines Lasers (dann auch als Laserablationsprozess bezeichnet) erfolgt.

Beispiel 32 ist eingerichtet gemäß einem der Beispiele 30 oder 31, wobei das Prozessmuster mehrere Paare von Bereichen (auch als Bestrahlungsbereiche bezeichnet), z.B. des Substratträger-Segments, implementiert, wobei die Bestrahlungsbereiche eines Paars symmetrisch zu der Symmetrieachse und/oder zu dem Winkel sind und unmittelbar nacheinander dem Prozess (z.B. Ablationsprozess und/oder Bestrahlungsprozess) ausgesetzt werden.

Beispiel 33 ist eingerichtet gemäß einem der Beispiele 30 bis 32, wobei das Prozessmuster symmetrisch ist zu einer Walzrichtung und/oder einem Walzrand des Substratträger-Segment oder zumindest eines Halbzeugs (z.B. einer Platte, z.B. Metallplatte), aus welchem das Substratträger-Segment gebildet wird.

Beispiel 34 ist eingerichtet gemäß einem der Beispiele 30 bis 33, wobei das Prozessmuster derart eingerichtet ist, dass eine von dem Ablationsprozess bewirkte Verspannung des Substratträger-Segments symmetrisch ist zu dem Winkel und/oder der Symmetrieachse.

Beispiel 35 ist eingerichtet gemäß einem der Beispiele 30 bis 34, wobei der Prozesses (z.B. Ablationsprozesses und/oder Bestrahlungsprozesses) ein Rauhlasern aufweist.

Beispiel 36 ist eingerichtet gemäß einem der Beispiele 30 bis 35, wobei der Prozesses (z.B. Ablationsprozesses und/oder Bestrahlungsprozesses) ein Laserschneiden (auch als Auslasern bezeichnet) aufweist.

Beispiel 37 ist ein Verfahren (vorzugsweise gemäß einem der Beispiele 1 bis 36), aufweisend: Ansteuern eines thermischen Prozesses (z.B. Ablationsprozesses und/oder Bestrahlungsprozesses) gemäß einem Prozessmuster; Bilden eines Substratträger-Segments (vorzugsweise eingerichtet gemäß einem der Beispiele 1 bis Beispiel 17) mittels des Ablationsprozesses, wobei das Prozessmuster symmetrisch ist zu einem Winkel, in dem zwei einander gegenüberliegende Stirnseiten des Substratträger-Segments zueinander verlaufen, und/oder zu einer Symmetrieachse des Substratträger-Segments.

Beispiel 38 ist eingerichtet gemäß einem der Beispiele 1 bis 37), wobei die Montagevorrichtung plattenförmig ist und/oder zum Einstecken in einen Aufnahmespalt eingerichtet ist.

Beispiel 39 ist eingerichtet gemäß einem der Beispiele 1 bis 38), wobei die Montagevorrichtung eine oder mehr als eine Aussparung (auch als Montageaussparungen bezeichnet) aufweist, welche in eine Richtung (z.B. Radialrichtung) von der Substrathaltevorrichtung weg, geöffnet ist.

Beispiel 40 ist eingerichtet gemäß einem der Beispiele 1 bis 39), wobei das Trägergestell monolithisch verbunden ist mit der die Montagevorrichtung und/oder den zwei Formschlusskonturen.

Beispiel 41 ist eingerichtet gemäß einem der Beispiele 1 bis 40), wobei eine erste der zwei Formschlusskonturen mittels eines Zentrierkeils und eine zweite der zwei Formschlusskonturen mittels eines zu dem Zentrierkeil komplementären Zentriertrichters bereitgestellt ist.

Beispiel 42 ist eingerichtet gemäß einem der Beispiele 1 bis 41), wobei eine erste der zwei Formschlusskonturen mittels eines Zapfens und eine zweite der zwei Formschlusskonturen mittels einer zu dem Zapfen komplementären Nut bereitgestellt ist.

Beispiel 43 ist eingerichtet gemäß einem der Beispiele 1 bis 42, der Substratträger-Segment ferner eine Symmetrieachse aufweisend, zu welcher ein Bearbeitungsmuster, gemäß welchem das Substratträger-Segment aufgeraut ist, symmetrisch ist.

Beispiel 44 ist eingerichtet gemäß einem der Beispiele 1 bis 43, der Substratträger-Segment ferner eine Symmetrieachse aufweisend, zu welcher eine Walzrichtung des Substratträger-Segment quer verläuft.

Beispiel 45 ist eingerichtet gemäß einem der Beispiele 1 bis 44, wobei die Symmetrieachse eine Winkelhalbierende eines Winkels ist, in dem zwei einander gegenüberliegende Stirnseiten des Substratträger-Segments zueinander verlaufen.

Beispiel 46 ist eingerichtet gemäß einem der Beispiele 1 bis 45, wobei zwei einander gegenüberliegende Stirnseiten des Substratträger-Segments übereinstimmen in einem Winkel, in dem diese zur Symmetrieachse des Substratträger-Segment verlaufen.

Es zeigen
Figur 1A und 2A jeweils ein Substratträger-Segment gemäß verschiedenen Ausführungsformen in einer schematischen Seitenansicht oder Querschnittsansicht;
Figur 1B einen Substratträger gemäß verschiedenen Ausführungsformen in einer schematischen Seitenansicht oder Querschnittsansicht;
Figur 2B und 3A jeweils eine Transportvorrichtung gemäß verschiedenen Ausführungsformen in verschiedenen schematischen Ansichten;
Figur 3B eine Aufnahmevorrichtung gemäß verschiedenen Ausführungsformen in einer schematischen Perspektivansicht;
Figur 4A einen Montagesockel gemäß verschiedenen Ausführungsformen in einer schematischen Perspektivansicht;
Figur 4B eine Transportvorrichtung gemäß verschiedenen Ausführungsformen in einer schematischen Seitenansicht oder Querschnittsansicht;
Figuren 5A und 5B jeweils ein Substratträger-Segment gemäß verschiedenen Ausführungsformen in einer schematischen Seitenansicht oder Querschnittsansicht;
Figur 5C eine Transportvorrichtung gemäß verschiedenen Ausführungsformen in einer schematischen Seitenansicht oder Querschnittsansicht;
Figuren 6A und 6B jeweils ein Substratträger-Segment gemäß verschiedenen Ausführungsformen in einer schematischen Seitenansicht oder Querschnittsansicht;
Figuren 7A und 7B jeweils ein Prozessmuster gemäß verschiedenen Ausführungsformen in einem schematischen Diagramm;
Figuren 8A und 8B jeweils ein Prozessmuster gemäß verschiedenen Ausführungsformen in einem schematischen Diagramm; und
Figuren 9A und 9B jeweils eine Vakuumanordnung gemäß verschiedenen Ausführungsformen in einer schematischen Seitenansicht oder Querschnittsansicht.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet). Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Gemäß verschiedenen Ausführungsformen kann eine Lagervorrichtung zum Lagern (z.B. geführten Positionieren und/oder Halten) eines oder mehr als eines Bauteils eingerichtet sein. Beispielsweise kann die Lagervorrichtung, zum Beispiel pro Bauteil, ein oder mehr als ein Lager aufweisen zum Lagern (z.B. geführten Positionieren und/oder Halten) des Bauteils. Jedes Lager der Ladevorrichtung kann eingerichtet sein, dem Bauteil einen oder mehr als einen Freiheitsgrad (beispielsweise Translationsfreiheitsgrad oder Rotationsfreiheitsgrad) bereitzustellen, gemäß welchem das Bauteil bewegt werden kann. Beispiele für ein Lager weisen auf: Radiallager, Axiallager, Radiaxlager, Linearlager (auch als Linearführung bezeichnet). Pro Linearlager kann dem Bauteil beispielsweise genau einen Translationsfreiheitsgrad bereitgestellt sein.

Als räumliche Position kann hierin die räumliche Information der Ausrichtung und/oder des Orts eines Objekts verstanden werden, beispielsweise bezogen auf eine oder mehr als eine Referenz (z.B. Schwerpunkt) des Objekts. Der Ort kann beispielsweise als Koordinatenpunkt im Raum und die Ausrichtung als Orientierung (z.B. als Richtung, Raumwinkel oder Vektor ausgedrückt) des Objekts relativ zu dem Raum angegeben werden. Der Ort eines Objekts kann beispielsweise als Ort des Massenschwerpunkts des Objekts im Raum angegeben werden. Alternativ oder zusätzlich kann die Ausrichtung als relative Lage (z.B. als Vektor oder Raumwinkel ausgedrückt) des Massenschwerpunkts und des geometrischen Schwerpunkt des Objekts angegeben werden.

Als Trajektorie kann eine Reihe von Positionen verstanden werden, entlang welcher eine Bewegung erfolgt (z.B. eines Laserstrahls, der auf die Positionen gerichtete wird). Die Positionen können optional mit einer zeitlichen Komponente verknüpft sein (d.h. bewegungsbezogen sein, dann auch als Bewegung bezeichnet) sein, z.B. eine Taktung oder Geschwindigkeit, gemäß welcher die Bewegung entlang der Trajektorie erfolgt. Im Allgemeinen kann die Position oder eine andere räumliche Information im dreidimensionalen Raum mittels kartesischer Koordinaten beschrieben werden. Es kann aber auch ein anderes Koordinatensystem verwendet werden, z.B. Zylinderkoordinaten.

Hierin wird insbesondere auf die Begriffe "Muster" (z.B. Prozessmuster) und "Sequenz" Bezug genommen, welche einer logischen Gruppierung von Vorgaben (z.B. ausgedrückt in Betriebsparametern), gemäß denen ein Laserstrahl auf ein Objekt (z.B. eine Metallplatte oder ein Substratträger-Segment) gerichtet wird, dienen. Das Muster korrespondiert anschaulich zu einer Soll-Leistungsverteilung, mit dem das Objekt bestrahlt werden soll, und wird während des Bestrahlungsprozesses, in dem der Laserstrahl auf das Objekt gerichtet wird, durchlaufen. Eine Sequenz kann anschaulich eine zeitliche Abfolge (auch als Reihenfolge bezeichnet) angeben, mit der das Bestrahlen erfolgt. Das Muster und die Sequenz können zusammen als Trajektorie ausgedrückt werden, welche, wenn auf das Objekt projiziert, die räumliche Leistungsverteilung (gemäß dem Muster) und die zeitliche Leistungsverteilung (gemäß der Sequenz) angibt.

Jedes Muster kann eine Folge von Parametern (auch als Bestrahlungsparameter bezeichnet) aufweisen oder daraus bestehen, gemäß denen das Bestrahlen des Objekts mit dem Laserstrahl erfolgt, z.B. eine Folge von genau N (auch als Punktzahl bezeichnet) Bestrahlungsparametern. Diesbezüglich kann verstanden werden, dass diese Gruppierung der Vorgaben exemplarisch ist, und dass das diesbezüglich Beschriebene selbstverständlich in Analogie in jeder anderen Art der Vorgaben, gemäß denen das Bestrahlen des Objekts erfolgt, gelten kann.

Als Montagevorrichtung wird hierin eine Vorrichtung verstanden, welche zum Montieren eingerichtet ist, beispielsweise zum Montieren an einer dazu komplementären Montagevorrichtung (auch als Gegen-Montagevorrichtung bezeichnet). Beim Montierens erfolgt ein (z.B. starres) Verbinden mehrerer Komponenten miteinander mittels ihrer Montagevorrichtungen. Das Montieren kann (beispielsweise ausschließlich) formschlüssig und/oder lösbar erfolgen. Die Montagevorrichtung kann vorzugsweise eine (z.B. planare) Montagefläche aufweisen, welche beim Montieren an einer dazu komplementären Montagefläche der Gegen-Montagevorrichtung anliegt. Die Montagevorrichtung kann beispielsweise ein oder mehr als ein (z.B. integrales) Montageprofil (z.B. Formschlussprofil) aufweisen, welches beispielsweise mittels einer Unebenheit (z.B. Vorsprung oder Vertiefung) der Montagevorrichtung bereitgestellt ist. Beispiele für das Montageprofil weisen auf: ein Gewinde, eine Nut (z.B. zur Passfederaufnahme und/oder Schwalbenschwanznut), eine Rastnase, ein Bajonettverschluss, ein Zapfen, usw. Beispiele für die Unebenheit weisen auf: eine Öffnung (z.B. Durchgangsöffnung und/oder Gewindebohrung), ein Bolzen (z.B. ein Gewindebolzen).
quaderförmiger) Fortsatz eines Bauteils verstanden, der eingerichtet ist, dieses mit einem anderen Bauteil zu verbinden. Beispielsweise kann der Zapfen als abgesetzter Endabschnitt bereitgestellt werden. Das zum Zapfen komplementäre kann beispielsweise einen (z.B. nutförmigen) Spalt aufweisen, in welchen der Zapfen (z.B. reibschlüssig und/oder aneinander abgleitend) passt. In dem Fall kann der Zapfen auch als Spundung (auch als Spund bezeichnet) bezeichnet werden, insbesondere wenn dieser ein dazu komplementäres Spundloch verschließt.

Gemäß verschiedenen Ausführungsformen kann die Vakuumkammer mittels eines Kammergehäuses bereitgestellt sein oder werden, in dem eine Kammer oder mehrere Kammern bereitgestellt sein oder werden können. Das Kammergehäuse kann beispielsweise zum Bereitstellen eines Unterdrucks oder eines Vakuums (Vakuumkammergehäuse) mit einer Pumpenanordnung, z.B. einer Vakuumpumpenanordnung, (z.B. gasleitend) gekoppelt sein und derart stabil eingerichtet sein, dass diese dem Einwirken des Luftdrucks im abgepumpten Zustand standhält. Die Pumpenanordnung (aufweisend zumindest eine Vakuumpumpe, z.B. eine Hochvakuumpumpe, z.B. eine Turbomolekularpumpe) kann es ermöglichen, einen Teil des Gases aus dem Inneren der Prozessierkammer, z.B. aus dem Prozessierraum, abzupumpen. Dementsprechend kann eine Vakuumkammer oder können mehrere Vakuumkammern in einem Kammergehäuse bereitgestellt sein. Mit anderen Worten kann das Kammergehäuse als Vakuumkammergehäuse eingerichtet sein bzw. kann eine Beschichtungskammer als eine Vakuumkammer eingerichtet sein.

Der Begriff "Stellglied" (z.B. einen Aktuator bzw. Aktor aufweisend) kann als ein Wandler verstanden werden, der zum Beeinflussen eines Zustandes, eines Vorgangs (z.B. eines Beschichtungsprozesses) oder einer Vorrichtung in Antwort auf ein Betätigen des Stellglieds eingerichtet ist. Das Stellglied kann ein diesem zugeführtes Wirkung (mittels dessen das Ansteuern erfolgt) in mechanische Bewegungen bzw. Veränderungen physikalischer Größen wie Kraft oder Bewegung umsetzen. Ein mechanisches Stellglied kann zum Beispiel eingerichtet sein, eine beim Betätigen dem Stellglied zugeführte Kraft (z.B. Drehmoment) in eine andere Kraft oder in eine Bewegung zu überführen. Beispiele für Komponenten eines Stellglieds weisen auf: ein Ventil (z.B. einer Pumpenanordnung und/oder Gaszuführvorrichtung, ein Motor (z.B. eines Ventils oder einer Pumpe), eine Stellschraube, ein Getriebe, oder Ähnliches.

Als Substratträger wird hierin eine Vorrichtung verstanden, welche eingerichtet ist, ein oder mehr als ein Substrat zu tragen. Dazu weist der Substratträger ein Gestell (auch als Trägergestell bezeichnet) auf, und eine oder mehr als eine Substrathaltevorrichtung, welche zumindest teilweise (d.h. teilweise oder vollständig) in das Gestell integriert und/oder zumindest teilweise an dem Gestell montiert sein kann. Beispiele für Komponenten der Substrathaltevorrichtung weisen auf: eine Vertiefung (auch als Substrattasche bezeichnet) zum Aufnehmen des Substrats; eine (z.B. ebene) Substratauflage, auf welche das Substrat aufgelegt werden kann (z.B. in der Substrattasche bereitgestellt); einen Arretierungsmechanismus, der eingerichtet ist, eine Bewegung des Substrats relativ zu der Substrathaltevorrichtung zu blockieren (z.B. formschlüssig und/oder kraftschlüssig). Das Gestell kann ferner einen oder mehr als einen Abschnitt aufweisen, an dem das Gestell getragen oder montiert werden kann. Beispielsweise kann der Abschnitt eine Montagevorrichtung aufweisen, um den Substratträger zu montieren.

Eine Beschichtungsvorrichtung ist eingerichtet zum Bereitstellen eines Beschichtungsmaterials, welchem beispielsweise der Transportpfad und/oder das Substrat ausgesetzt sind. Das Beschichtungsmaterials kann beispielsweise zu dem Transportpfad und/oder dem Substrat hin emittiert werden, z.B. in eines sogenannte Emissionsrichtung. Die Beschichtungsvorrichtung weist beispielsweise eine Beschichtungsmaterialquelle auf, mittels welcher das Beschichtungsmaterial bereitgestellt (z.B. emittiert) wird. Die Beschichtungsvorrichtung kann beispielsweise zum Durchführen einer Gasphasenabscheidung eingerichtet sein, z.B. einer physikalischen Gasphasenabscheidung (PVD) oder chemischen Gasphasenabscheidung (CVD).

Beispielsweise kann die Beschichtungsmaterialquelle zum Bereitstellen eines gasförmigen Beschichtungsmaterials (Materialdampf) und/oder flüssigen Beschichtungsmaterials eingerichtet sein, welches z.B. auf dem zumindest einen Substrat zum Bilden einer Schicht abgeschieden werden kann. Eine Beschichtungsmaterialquelle kann zumindest eines von Folgendem aufweisen: eine Sputtervorrichtung, eine thermisch-Verdampfen-Vorrichtung (z.B. einen Laserstrahlverdampfer, einen Lichtbogenverdampfer, einen Elektronenstrahlverdampfer und/oder einen thermischen Verdampfer), eine Präkursorgasquelle, einen Flüssigphasenzerstäuber. Eine Sputtervorrichtung kann zum Zerstäuben des Beschichtungsmaterials mittels eines Plasmas eingerichtet sein. Eine thermisch-Verdampfen Vorrichtung kann zum Verdampfen des Beschichtungsmaterials mittels thermischer Energie eingerichtet sein. Je nach der Beschaffenheit des Beschichtungsmaterials kann alternativ oder zusätzlich zu dem thermischen Verdampfen, d.h. ein thermisches Überführen eines flüssigen Zustands (flüssige Phase) in einen gasförmigen Zustand (gasförmige Phase), auch ein Sublimieren, d.h. ein thermisches Überführen eines festen Zustands (feste Phase) in einen gasförmigen Zustand, auftreten. Mit anderen Worten kann die thermisch-Verdampfen-Vorrichtung das Beschichtungsmaterial auch sublimieren. Ein Flüssigphasenzerstäuber kann zum Aufbringen eines Beschichtungsmaterials aus der Flüssigphase eingerichtet sein, z.B. eines Farbstoffs.

Zur vereinfachten Veranschaulichung der Geometrie verschiedener Komponenten, wie beispielsweise des Substratträger-Segments, des Substratträgers und/oder Haltevorrichtung, wird hierin exemplarisch auf die Seiten Bezug genommen.

Hinsichtlich verschiedener Ausführungsformen wird auf eine Symmetrieachse eines Objekts (z.B. eines Substratträger-Segments) Bezug genommen, wobei verstanden werden kann, dass nicht notwendigerweise jede Kontur des Objekts symmetrisch zu der Symmetrieachse sein muss. Beispielsweise kann das Objekt eine gekrümmte Außenseite aufweisen, die symmetrisch zu der Symmetrieachse ist. Beispielsweise kann das Objekt eine oder mehr als eine Oberfläche (z.B. Substratauflagefläche) aufweisen, die symmetrisch zu der Symmetrieachse ist. Beispielsweise kann das Objekt mehrere Aussparungen aufweisen, die symmetrisch zu der Symmetrieachse ist. Beispielsweise kann das Objekt zwei Außenkanten aufweisen, die symmetrisch zu der Symmetrieachse ist. Beispielsweise kann sich das Objekt symmetrisch zu der Symmetrieachse verjüngen und/oder entlang der Symmetrieachse. Beispiele für die Symmetrie weisen auf: Spiegelsymmetrie, Translationssymmetrie, Drehsymmetrie oder Kombinationen davon.

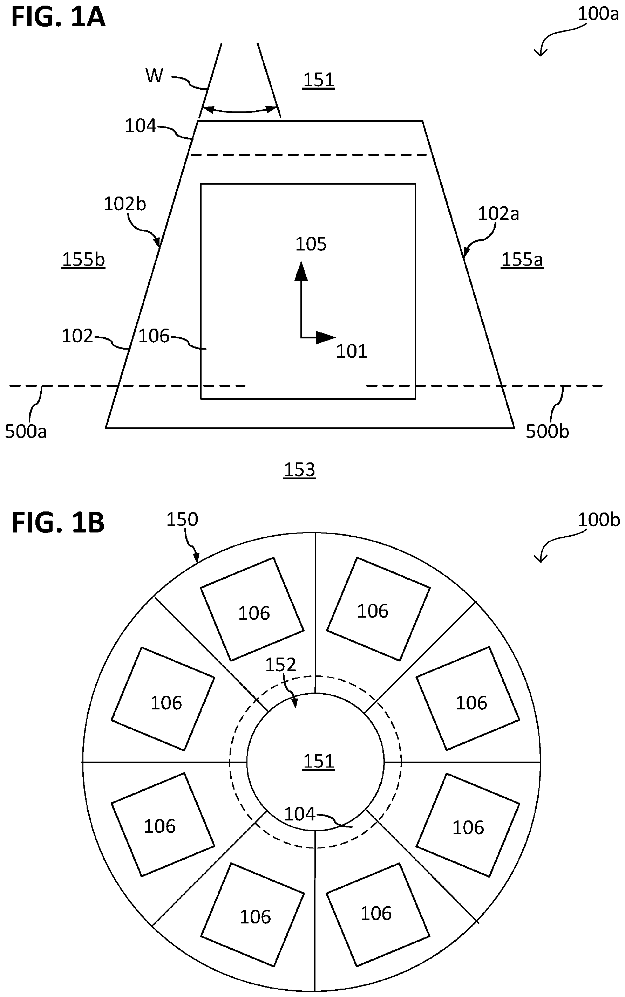

**Fig.1A** veranschaulicht ein Substratträger-Segment gemäß verschiedenen Ausführungsformen 100a in einer schematischen Seitenansicht oder Querschnittsansicht, vorzugsweise eingerichtet gemäß Beispiel 1 und/oder Beispiel 2, wobei die Radialrichtung 105 und die Transportrichtung 101 angegeben sind (im Bezugssystem des Substratträger-Segments).

Zur vereinfachten Veranschaulichung der Geometrie des Substratträger-Segments wird auf dessen Innenseite 151 und Außenseite 153 Bezug genommen, zwischen denen die Substrathaltevorrichtung 106 angeordnet ist, und auf dessen zwei Stirnseiten 155a, 155b Bezug genommen. Die Radialrichtung 105 ist von der Außenseite 153 zu der Innenseite 151 hin gerichtet. Die Montagevorrichtung 104 kann der Innenseite 151 zugewandt sein, zu welcher sich das Trägergestell 102 hin verjüngt.

Eine exemplarische Implementierung (vorzugsweise gemäß Beispiel 40) des Substratträger-Segments weist eine monolithische Platte auf, welche das Trägergestell 102 und die Montagevorrichtung 104 aufweist. Alternativ oder zusätzlich (vorzugsweise gemäß Beispiel 38) sind die Montagevorrichtung 104 und das Trägergestell 102 plattenförmig. Es kann verstanden werden, dass das Trägergestell 102 und die Montagevorrichtung 104 auch formschlüssig gefügt sein können, z.B. miteinander geschraubt sein können.

Eine exemplarische Implementierung der Substrathaltevorrichtung 106 weist eine Vertiefung auf, welche sich in die Platte hinein erstreckt.

Die den Stirnseiten 155a, 155b zugewandten Ränder 102a, 102b des Trägergestells 102 (auch als Trägerränder 102a, 102b bezeichnet) können schräg zueinander und/oder schräg zu der Radialrichtung 105 verlaufen, z.B. geradlinig sein. Dies erreicht, dass das Trägergestell 102 zu der Innenseite 151 hin verjüngt. Alternativ oder zusätzlich weist die Montagevorrichtung 104 zwei gegenüberliegende Ränder auf, welche die Trägerränder 102a, 102b fortsetzen.

Die den Stirnseiten 155a, 155b zugewandten Ränder 102a, 102b des Trägergestells 102 können in einem Winkel W (auch als Seitenwinkel bezeichnet) zueinander verlaufen, dessen Winkelhalbierende entlang der Radialrichtung 105 ist. Der Winkel kann ungefähr folgende Relation erfüllen: W = 360°/k, wobei der Parameter k (auch als Zähligkeit k bezeichnet) eine natürliche Zahl größer als 2 ist, z.B. k≥3, z.B. k≥4, z.B. k≥6, z.B. k≥8, z.B. k≥10. Die Zähligkeit k gibt anschaulich die Anzahl der Substratträger-Segment an, die zusammengefügt einen Substratträger bilden, wie nachfolgend erläutert wird.

**Fig.1B** veranschaulicht einen Substratträger gemäß verschiedenen Ausführungsformen 100b in einer schematischen Seitenansicht oder Querschnittsansicht, welcher mehrere Substratträger-Segmente 150 aufweist, die vorzugsweise eingerichtet sind gemäß Ausführungsformen 100a. Die Zähligkeit k beträgt exemplarisch 8.

Die mehreren Substratträger-Segmente 150 können zusammengefügt (auch als zusammengefügter Zustand bezeichnet) eine ringförmige Struktur bilden, in welcher eine Öffnung 152 (auch als Trägeröffnung 152 bezeichnet) des Substratträgers gebildet ist. Die Montagevorrichtung 104 jedes Substratträger-Segmentes 150 kann an die Trägeröffnung 152 angrenzen.

Die Trägeröffnung 152 stellt anschaulich Bauraum für eine Substratträger-Haltevorrichtung bereit, welche beispielsweise eine Nabe aufweist. Die Trägerränder einander unmittelbar benachbarter Substratträger-Segmente 150 können im zusammengefügten Zustand ineinander greifen, wie später noch genauer erläutert wird.

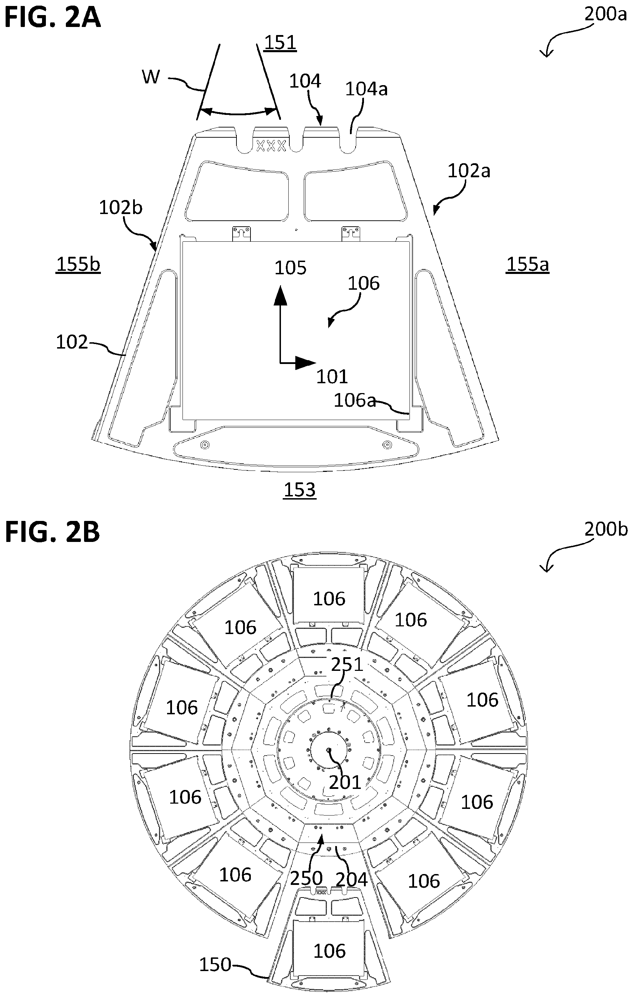

**Fig.2A** veranschaulicht ein Substratträger-Segment gemäß verschiedenen Ausführungsformen 200a in einer schematischen Seitenansicht oder Querschnittsansicht, vorzugsweise eingerichtet gemäß einer der Ausführungsformen 100a bis 100b.

Eine exemplarische Implementierung der Montagevorrichtung 104 weist eine oder mehr als eine Formschlusskonturen auf, um die Montage zu erleichtern. Eine exemplarische Implementierung eine Formschlusskonturen (vorzugsweise gemäß Beispiel 39) ist mittels einer Montageaussparung bereitgestellt, welche in die Radialrichtung 105 geöffnet ist. Jede Montageaussparung 104a kann sich beispielsweise in die Radialrichtung 105 verjüngen. Dies erleichtert die Montage.

Eine exemplarische Implementierung (vorzugsweise gemäß) der Substrathaltevorrichtung 106 weist eine Auflagefläche 106a (auch als Substratauflage bezeichnet) auf, welche die Vertiefung begrenzt. Beispielsweise kann die Auflagefläche 106a mittels eines Vorsprungs bereitgestellt sein.

**Fig.2B** veranschaulicht eine Transportvorrichtung, welche eine Substratträger-Haltevorrichtung 250 und einen Substratträger (vorzugsweise eingerichtet gemäß Beispiel 18) aufweist, gemäß verschiedenen Ausführungsformen 200b in einer schematischen Seitenansicht oder Querschnittsansicht, vorzugsweise eingerichtet gemäß einer der Ausführungsformen 100a bis 200a. Die Zähligkeit k beträgt exemplarisch 10.

Im Bezugssystem des Substratträgers ist die Radialrichtung 105 jedes Substratträger-Segments auf die Drehachse 201 gerichtet und/oder senkrecht zu der Drehachse 201. Im Betrieb kann der Substratträger gedreht werden um die Drehachse 201 herum, so dass jedes Substratträger-Segment entlang eines kreisförmigen Transportpfads transportiert wird. Die Transportrichtung 101 jedes Substratträger-Segments kann tangential zu dem Transportpfads und/oder senkrecht zu der Drehachse 201 sein.

Die Substratträger-Haltevorrichtung 250 weist eine Anzahl von k Montagesockel 204 aufweisen, beispielsweise pro Substratträger-Segment 150 einen Montagesockel 204. Der Montagesockel 204 ist eingerichtet, eine Verbindung mit der Montagevorrichtung 104 herzustellen, um das Substratträger-Segments 150 an der Substratträger-Haltevorrichtung 250 zu montieren.

Eine exemplarische Implementierung der Substratträger-Haltevorrichtung 250 (vorzugsweise gemäß Beispiel 19) weist ferner eine Lagervorrichtung 251 (auch als Nabe bezeichnet) auf, mittels welcher der Montagesockel 204 drehbar gelagert sind um eine Drehachse 201 der Lagervorrichtung herum. Dazu kann die Lagervorrichtung ein oder mehr als ein Drehlager aufweisen, mittels welchem die Drehachse 201 bereitgestellt ist.

Das Montieren eines Substratträger-Segment 150 kann aufweisen, das Substratträger-Segment 150 in die Radialrichtung an die Substratträger-Haltevorrichtung 250 zu bewegen, so dass die Montagevorrichtung 104 und die Montagesockel 204 einander berühren, beispielsweise ineinandergreifend.

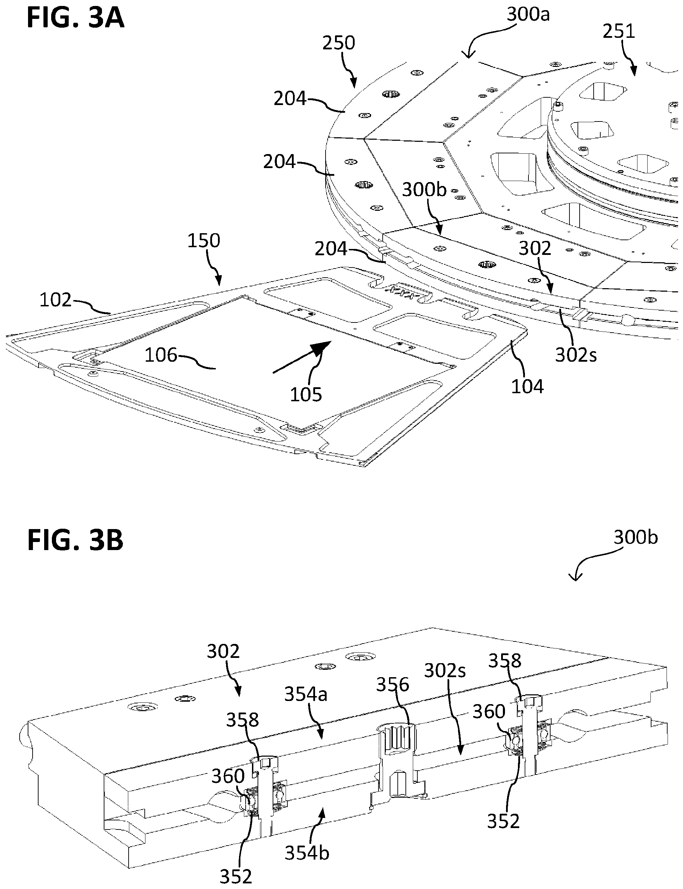

**Fig.3A** veranschaulicht ein Transportvorrichtung, welche eine Substratträger-Haltevorrichtung 250 und einen Substratträger (vorzugsweise eingerichtet gemäß Beispiel 18) aufweist gemäß verschiedenen Ausführungsformen 300a in einer schematischen Perspektivansicht, vorzugsweise eingerichtet gemäß einer der Ausführungsformen 100a bis 200b.

Eine exemplarische Implementierung des Montagesockels 204 (vorzugsweise eingerichtet gemäß Beispiel 21) weist eine Aufnahmevorrichtung 302 zum Aufnehmen eines Substratträger-Segments 150 auf, die einen Aufnahmespalt 302s bereitstellt. Der Aufnahmespalt 302s ist zum Aufnehmen der Montagevorrichtung 104 eingerichtet, beispielsweise derart, dass die Montagevorrichtung 104 in den Aufnahmespalt 302s eingesteckt werden kann.

**Fig.3B** veranschaulicht eine Aufnahmevorrichtung (vorzugsweise eingerichtet gemäß Beispiel 22), gemäß verschiedenen Ausführungsformen in einer schematischen Querschnittsansicht 300b, vorzugsweise eingerichtet gemäß einer der Ausführungsformen 100a bis 300a.

Eine exemplarische Implementierung (vorzugsweise gemäß Beispiel 23) der Aufnahmevorrichtung 302 weist eine oder mehr als eine Feder 352 auf, welche in dem Aufnahmespalt 302s zwischen den zwei Spannbacken 354a, 354b angeordnet ist. Die Feder 352 ist eingerichtet, eine erste Kraft (auch als Rückstellkraft bezeichnet) zwischen den Spannbacken zu vermitteln, entgegen welcher die Spannbacken 354a, 354b auf einander zu bewegt werden können. Ferner weist der Montagesockel 204 eine oder mehr als eine Schraube als Stellglied 356 (auch als Montageglied bezeichnet) auf. Das Montageglied 356 ist eingerichtet, einen Abstand der zwei Spannbacken 354a, 354b voneinander zu beeinflussen, beispielsweise indem die Schraube (dann auch als Spannschraube bezeichnet) gedreht wird. Das Montageglied 356 kann beispielsweise eingerichtet sein, in eine Montageaussparung 104a der Montagevorrichtung 104 hineinzugreifen. Dies erleichtert die Montage.

Die oder eine dazu alternative exemplarische Implementierung (vorzugsweise gemäß Beispiel 23) der Aufnahmevorrichtung 302 weist eine oder mehr als eine Formschlusskontur (auch als Sockelkontur bezeichnet) als Führungsglied auf, welche in den Aufnahmespalt 302s hineinerstreckt ist und/oder eingerichtet ist, mit der Montagevorrichtung 104 ineinanderzugreifen. Eine exemplarische Implementierung (vorzugsweise gemäß) des Führungsglieds ist beispielsweise mittels eines Vorsprungs 358 (auch als Führungsglied bezeichnet) implementiert, welcher in den in den Aufnahmespalt 302s hinein ragt. Beispielsweise kann die Aufnahmevorrichtung 302 zwei Führungsglieder 358 aufweisen, zwischen denen beispielsweise das Montageglied 356 angeordnet ist.

Jedes Führungsglied 358 kann beispielsweise eingerichtet sein, in eine Montageaussparung 104a der Montagevorrichtung 104 hineinzugreifen. Dies erleichtert die Montage. Beispielsweise kann jeder des Führungsglied 358 durch eine der Federn hindurch erstreckt sein und/oder mittels einer Schraube implementiert sein.

Eine exemplarische Implementierung (vorzugsweise gemäß Beispiel 24) des Führungsglieds 358 weist ein Kugellager 360 auf, welches einen drehbar gelagerten Ring bereitstellt. Dies erleichtert die Montage. Beispielsweise kann die Aufnahmevorrichtung, pro Führungsglied, zwei Federn aufweisen, zwischen denen das Kugellager 360 angeordnet ist, so dass die Rückstellkraft mittels des Kugellagers 360 vermittelt wird. Dies erleichtert die Konstruktion, da weniger Teile benötigt werden, um das Kugellager 360 zu halten und die Rückstellkraft zu erzeugen.

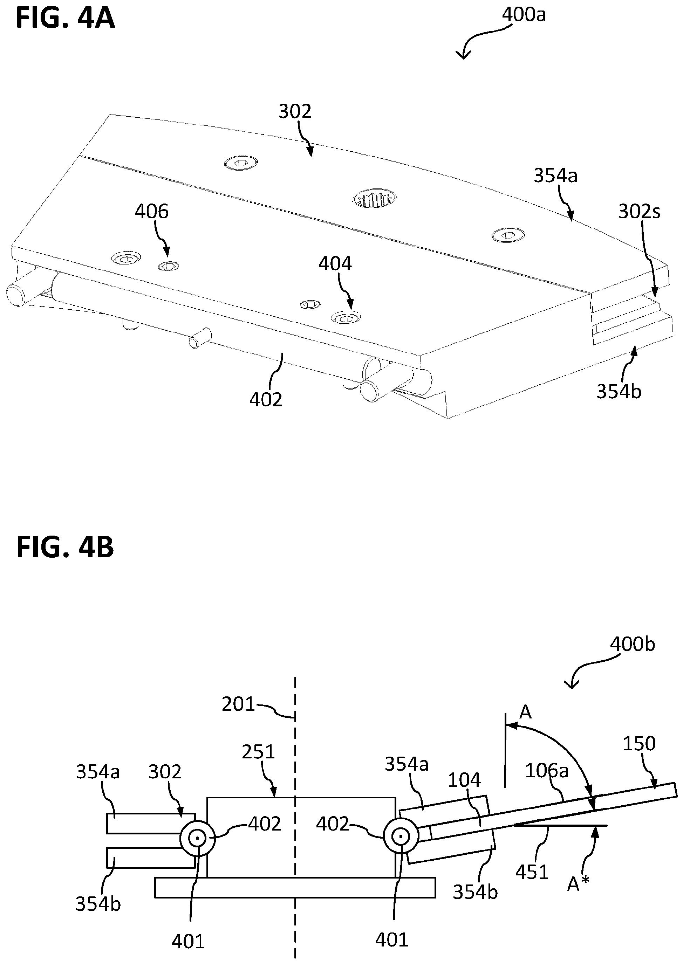

**Fig.4A** veranschaulicht einen Montagesockel (vorzugsweise eingerichtet gemäß Beispiel 20) gemäß verschiedenen Ausführungsformen 400a in einer schematischen
Perspektivansicht, vorzugsweise eingerichtet gemäß einer der Ausführungsformen 100a bis 300b. Die Lagervorrichtung 402 des Montagesockels (auch als Sockellager 402 bezeichnet) stellt anschaulich ein Drehgelenk bereit, welches die Aufnahmevorrichtung 302 beweglich mit der Nabe 251 verbindet.

Eine exemplarische Implementierung des Sockellagers 402 stellt eine Drehachse (auch als Ausrichtungsachse bezeichnet) bereit, welche in einem Abstand von der Aufnahmevorrichtung 302 oder zumindest von dem Aufnahmespalt 302s angeordnet ist. Dies erreicht, dass die Ausrichtung der Aufnahmevorrichtung 302 oder zumindest des Aufnahmespalts 302s verändert werden kann.

Eine exemplarische Implementierung des ersten Stellglieds 404 (auch als Ausrichtungsglied bezeichnet) weist eine oder mehr als eine Schraube (auch als Ausrichtungsschraube bezeichnet) auf, welche beispielsweise in die Aufnahmevorrichtung 302 eingeschraubt ist. Die Ausrichtungsschraube ist eingerichtet, die Ausrichtung der Aufnahmevorrichtung 302 relativ zu einer Ebene (auch als Referenzebene bezeichnet), die quer zu der Drehachse 201 ist, zu verändern, beispielsweise indem die Ausrichtungsschraube gedreht ist. Die verändert den Winkels zwischen der Drehachse 201 und der Aufnahmevorrichtung 302.

Beispielsweise kann die Ausrichtungsschraube eingerichtet sein, eine Kraft zu vermitteln zwischen der Aufnahmevorrichtung 302 und der Nabe 251. Dazu kann die Ausrichtungsschraube beispielsweise durch die Aufnahmevorrichtung 302 hindurch erstreckt sein und mit ihrem Endabschnitt gegen eine Stützvorrichtung der Nabe 251 pressen, wenn die Aufnahmevorrichtung 302 hinein gedreht wird.

Eine exemplarische Implementierung der Arretierungsvorrichtung 406 weist eine oder mehr als eine Schraube (auch als Arretierungsschraube bezeichnet) auf, welche eingerichtet ist, den Rotationsfreiheitsgrad der Aufnahmevorrichtung 302, welche mittels des Sockellagers 402 bereitgestellt ist, zu blockieren, beispielsweise indem die Arretierungsschraube hineingedreht wird, oder freizugeben, beispielsweise indem die Arretierungsschraube herausgedreht wird. Dies erleichtert es, eine präzise Ausrichtung der Substratträger-Segmente vorzunehmen und diese zu arretieren.

Alternativ oder zusätzlich kann die Arretierungsvorrichtung 406 eingerichtet sein, einen Winkel, um welchen die Aufnahmevorrichtung 302 bewegt werden kann, zu begrenzen auf einen Bereich (auch als Schwenkbereich bezeichnet), der eine Funktion ist von einem Zustand der Arretierungsvorrichtung 406. Vorzugsweise kann die Arretierungsvorrichtung 406 eingerichtet sein, den Schwenkbereich zu verkleinern, wenn diese in einen ersten Zustand gebracht wird, z.B. mittels Drehens der Arretierungsschraube). Vorzugsweise kann die Arretierungsvorrichtung 406 eingerichtet sein, den Schwenkbereich zu vergrößern, wenn diese in einen zweiten Zustand gebracht wird, z.B. mittels Drehens der Arretierungsschraube).

**Fig.4B** veranschaulicht eine Transportvorrichtung, welche eine Substratträger-Haltevorrichtung 250 und einen Substratträger (vorzugsweise eingerichtet gemäß Beispiel 18) aufweist, gemäß verschiedenen Ausführungsformen 400b in einer schematischen Seitenansicht oder Querschnittsansicht, vorzugsweise eingerichtet gemäß einer der Ausführungsformen 100a bis 400a. Die Ausrichtungsachse 401 jedes Montagesockels 204s kann quer zu der Drehachse 201 der Nabe 251 sein und/oder parallel zu der Referenzebene 451 sein.

Die Referenzebene 451 kann anschaulich als Bezugsebene dienen für die Ausrichtung der Substratauflagefläche und/oder für den Ausrichtungswinkel A. Beispielsweise kann der Ausrichtungswinkel A. im Betrieb ungefähr 90° sein. Der Wechselwinkel A* des Ausrichtungswinkels A kann beispielsweise zwischen der Referenzebene 451 und der Substratauflagefläche eingeschlossen sein.

Anschaulich kann das Substratträger-Segment, wenn mittels seiner Montagevorrichtung 104 montiert (auch als montierter Zustand bezeichnet), als Kragträger aufgefasst werden, welcher sich aufgrund der darauf wirkenden Gravitationskraft verformt, beispielsweise gemäß einer Biegeline. Die Position des Substratträger-Segments im montierten Zustand relativ zu der Referenzebene kann unter anderem eine Funktion der Verformung sein und/oder verschiedener Parameter (z.B. Eigenschaften des Substratträger-Segments und/oder des Montagesockels), welche sich für mehrere Substratträger-Segment voneinander unterscheiden können.

Beispiele für diese Parameter (auch als Positionsparameter bezeichnet), welche sich für mehrere Substratträger-Segmente des Substratträgers voneinander unterscheiden können (auch als Positionsparametervarianz bezeichnet), weisen auf: eine Krümmung im unbelasteten Zustand, eine mechanische Steifigkeit, eine Position im montierten Zustand bezüglich des Montagesockels, eine (z.B. thermische und/oder mechanische) Beanspruchung im montierten Zustand, eine Vorgeschichte, eine Kristallstruktur des Substratträger-Segments, usw. Einige der Eigenschaften eines Substratträger-Segments können zeitabhängig sein, und sich beispielsweise im Laufe der Zeit verändern (beispielsweise aufgrund der thermischen Belastung). Ebenso können Toleranzen (der Herstellung und/oder Montage) dazu führen, dass sich diese Positionsparameter voneinander unterscheiden. Dies gilt in Analogie für die Montagesockel untereinander.

Die Positionsparametervarianz hat zur Folge, dass sich, z.B. trotz einer präzisen Fertigung der Montagesockel und der Substratträger-Segmente und Montage dieser aneinander, mehrere Substratträger-Segmente des Substratträgers in ihrer Position (z.B. der Position der Substratauflagefläche 106a) relativ zu der Referenzebene voneinander unterscheiden (auch als Positionsunterschied bezeichnet). Dieser Positionsunterschied kann beispielsweise mittels Veränderns des Ausrichtungswinkels A verringert werden. Dazu kann das Betätigen des Ausrichtungsglied und/oder das Verändern des Ausrichtungswinkels A gemäß einer Vorgabe erfolgen, welche eine Soll-Position des Substratträger-Segments repräsentiert.

In analoger Weise können die Stützkonturen, insofern vorhanden, dazu beitragen, den Positionsunterschied zu reduzieren. Nachfolgend werden verschiedene Implementierungen der Stützkonturen erläutert.

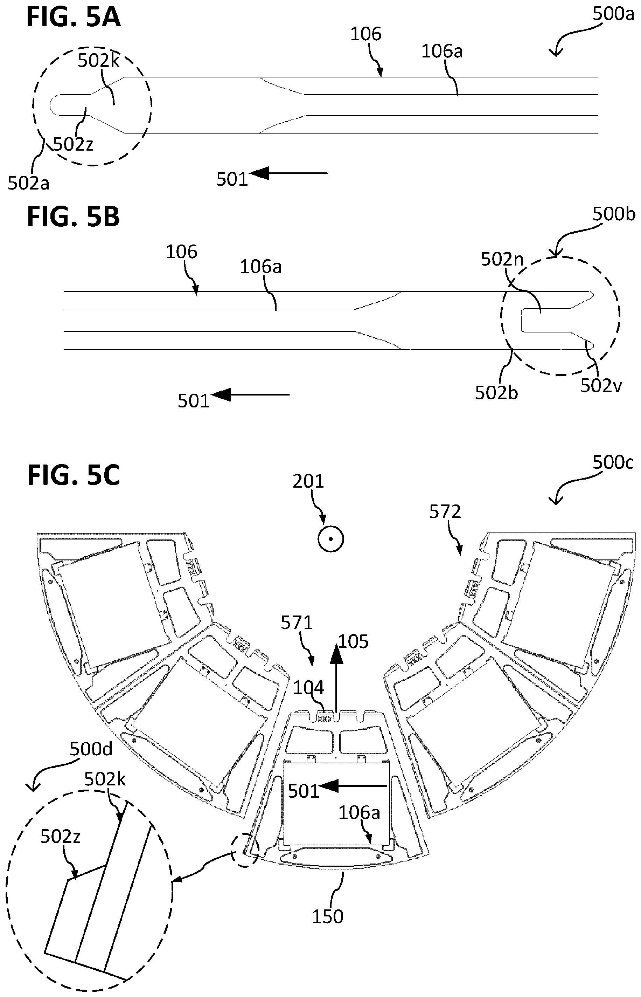

**Fig.5A** und **5B** veranschaulichen jeweils ein Substratträger-Segment (vorzugsweise eingerichtet gemäß Beispiel 1 und/oder Beispiel 2) gemäß verschiedenen Ausführungsformen in einer schematischen Querschnittsansicht 500a und 500b mit Blickrichtung in die Radialrichtung 105, vorzugsweise eingerichtet gemäß einer der Ausführungsformen 100a bis 400b. Ferner ist eine Richtung 501 (zur Veranschaulichung auch als Steckrichtung 501 bezeichnet) dargestellt, welche beispielsweise die Transportrichtung 101 oder antiparallel zu der Transportrichtung 101 ist.

Die zwei Trägerränder 102a, 102b, z.B. deren erster Trägerrand 102a, können eine erste Stützkonturen 502a aufweisen. Die zwei Trägerränder 102a, 102b, z.B. deren zweiter Trägerrand 102b, können eine zweite Stützkonturen 502b aufweisen, welche komplementär zu der ersten Stützkontur 502a eingerichtet ist. Die erste Stützkontur 502a und die zweite Stützkontur 502b können beispielsweise zum Ineinandergreifen (auch als Konturineinandergreifen bezeichnet) eingerichtet sein und/oder einander gegenüberliegen. Die Stützkonturen ermöglichen, dass zwei einander unmittelbar gegenüberliegende Substratträger-Segmente des Substratträgers mit ihren Stützkonturen ineinandergreifen und sich dabei aneinander ausrichten (auch als Zentrieren bezeichnet) und gegenseitig stützen.

Diese hemmt den Positionsunterschied.

Eine exemplarische Implementierung der ersten Stützkontur 502a (vorzugsweise gemäß Beispiel 11) ist mittels eines (z.B. gestuften) Vorsprungs implementiert, welcher hervorsteht, z.B. in die Steckrichtung 501 von der Substrathaltevorrichtung 106 weg. Der Vorsprung kann beispielsweise einen keilförmigen Abschnitt 502k aufweisen und/oder sich zumindest abschnittsweise in die Steckrichtung 501 verjüngen, was das Zentrieren verbessert. Alternativ oder zusätzlich kann der Vorsprung einen zapfenförmigen Abschnitt 502z (auch als Zapfen 502z bezeichnet) aufweisen, welcher beispielsweise einen Spund bereitstellt und/oder den keilförmigen Abschnitt 502k (auch als Zentrierkeil 502k bezeichnet) fortsetzt, z.B. von diesem hervorstehend in die Steckrichtung 501.

Eine exemplarische Implementierung der zweiten Stützkontur 502b ist mittels einer (z.B. gestuften) Vertiefung implementiert, welche in eine Richtung von der Substrathaltevorrichtung 106 weg (aus der Steckrichtung 501) geöffnet ist. Die Vertiefung kann beispielsweise einen trichterförmigen Abschnitt 502v (auch als Zentriertrichter bezeichnet) aufweisen und/oder sich zumindest abschnittsweise zu der Substrathaltevorrichtung 106 hin (und/oder aus der Steckrichtung 501) verjüngen, was das Zentrieren verbessert. Alternativ oder zusätzlich kann die Vertiefung einen nutförmigen Abschnitt 502n (auch als Nut 502n bezeichnet) aufweisen, welcher beispielsweise ein Spundloch bereitstellt und/oder den verjüngenden Abschnitt 502v fortsetzt, z.B. in die Steckrichtung 501.

Die erste Stützkontur 502a und zweite Stützkontur 502b können beispielsweise zum Eineinanderstecken eingerichtet sein. Beim Eineinanderstecken kann beispielsweise der Zapfen 502z in den Zentriertrichter 502v eingebracht werden, z.B. an dessen Innenwand abgleitend, und danach in die Nut 502n eingebracht werden, z.B. an dessen Innenwand abgleitend.

Eine exemplarische Implementierung des Zapfens 502z und/oder der Nut 502n sind derart eingerichtet, dass diese im ineinandergesteckten Zustand weniger als 10^{-g} cm (Zentimeter) Spiel zueinander aufweisen (z.B. quer zu der Steckrichtung 501), wobei g≥0 ist, z.B. g≥1, z.B. g≥2.

Eine exemplarische Implementierung des Zentrierkeils 502k und/oder des Zentriertrichter 502v sind derart eingerichtet, dass diese im ineinandergesteckten Zustand weniger als 10^{-g} cm (Zentimeter) Spiel zueinander aufweisen (z.B. quer zu der Steckrichtung 501), wobei g≥0 ist, z.B. g≥1, z.B. g≥2.

**Fig.5C** veranschaulicht einen Substratträger (vorzugsweise eingerichtet gemäß Beispiel 18) gemäß verschiedenen Ausführungsformen in einer schematischen Draufsicht 500c mit Blickrichtung entlang der Drehachse 201, vorzugsweise eingerichtet gemäß einer der Ausführungsformen 100a bis 500b, und einer Detailansicht 500d davon.

Eine exemplarische Implementierung eines Verfahrens zum Bilden des Substratträger weist auf, ein Substratträger-Segment 150 in einen Bereich 571 (auch als Segmentbereich bezeichnet) hinein zu transportieren (auch als Segmenthinzufügen bezeichnet), welcher zwischen zwei einander unmittelbar benachbarten Substratträger-Segmenten einer Gruppe 572 von Substratträger-Segmenten (auch als Segmentgruppe 572 bezeichnet) gebildet ist, z.B. zu der Drehachse 201 hin, z.B. entlang seiner Radialrichtung 105, welche auf die Drehachse 201 gerichtet ist. Bei dem Segmenthinzufügen kann das Eineinanderstecken erfolgen, indem beispielsweise die erste Formschlusskontur 502a des Substratträger-Segments 150 in eine an den Segmentbereich angrenzenden zweite Formschlusskontur 502b der Segmentgruppe 572 eingebracht wird. Beispielsweise kann der Zapfen 502z des Substratträger-Segments 150 in einen an den Segmentbereich angrenzenden Zentriertrichter 502v der Segmentgruppe 572 eingebracht werden, z.B. an dessen Innenwand abgleitend, und danach in eine den Zentriertrichter 502v fortsetzende Nut 502n der Segmentgruppe 572 eingebracht werden, z.B. an dessen Innenwand abgleitend. Beim Eineinanderstecken kann der Substratträger-Segment 150 an der Segmentgruppe 572 ausgerichtet werden (auch als Zentrieren bezeichnet).

Beim Segmenthinzufügen kann beispielsweise die Montagevorrichtung 104 ferner von der Aufnahmevorrichtung (nicht dargestellt) der Substratträger-Haltevorrichtung aufgenommen werden, z.B. von dem Aufnahmespalt.

Das Verfahren kann ferner aufweisen, den Substratträger-Segment 150 mittels seiner Montagevorrichtung 104 an der Substratträger-Haltevorrichtung (z.B. deren Montagesockel) zu montieren (auch als Montieren des Substratträger-Segments bezeichnet) und/oder diesen auszurichten (auch als Ausrichten des Substratträger-Segments bezeichnet).

Eine exemplarische Implementierung des Ausrichtens des Substratträger-Segments 150 weist auf, das erste Stellglied zu betätigen, so dass ein Winkels zwischen der Substratauflagefläche 106a des Substratträger-Segment 150 und der Drehachse 201 verändert wird. Das Ausrichten des Substratträger-Segments 150 kann optional aufweisen, die Arretierungsvorrichtung zu betätigen, so dass eine Veränderung des Winkels zwischen der Substratauflagefläche 106a des Substratträger-Segment 150 und der Drehachse 201 blockiert wird.

Eine exemplarische Implementierung des Montierens des Substratträger-Segments weist auf, das zweite Stellglied zu betätigen, so dass die Montagevorrichtung 104 formschlüssig und/oder kraftschlüssig mit dem Montagesockel (nicht dargestellt) verbunden wird. Wie hierin erläutert kann das das zweite Stellglied beispielsweise eingerichtet sein, eine Kraft auf die Spannbacken zu übertragen, welche eine Bewegung der Spannbacken aufeinander zu auslöst und/oder die Montagevorrichtung 104 mittels der Spannbacken einklemmt.

Es kann verstanden werden, dass das Verfahren alternativ oder zusätzlich in umgekehrter Reihenfolge ablaufen kann, um ein Substratträger-Segment von dem Substratträger zu entfernen.

Es kann verstanden werden, dass das Verfahren im Allgemeinen ein Segmenttauschen aufweisen kann. Das Segmenttausch kann beispielsweise aufweisen, ein erstes Substratträger-Segment des Substratträgers gegen ein zweites Substratträger-Segment auszutauschen. Alternativ kann das Segmenttausch aufweisen, das erste Substratträger-Segment des Substratträgers zu demontieren, das darin angeordnete Substrat gegen ein anderes Substrat auszutauschen, und das erste Substratträger-Segment wieder zu montieren.

Das Segmenttauschen kann beispielsweise mittels einer Transportvorrichtung (auch als Segment-Transportvorrichtung oder Handler bezeichnet) erfolgen, z.B. eines Endeffektors der Segment-Transportvorrichtung. Beispielsweise kann der Endeffektor mit dem Substratträger-Segment gekuppelt werden, bevor das Substratträger-Segment von dem Substratträgers entfernt wird.

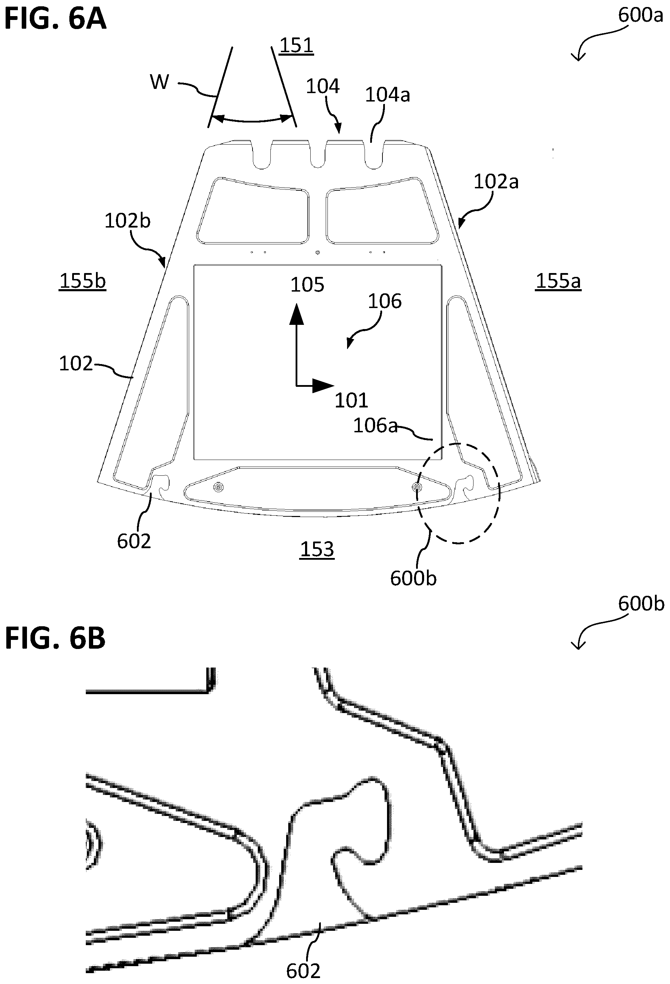

**Fig.6A** veranschaulicht ein Substratträger-Segment gemäß verschiedenen Ausführungsformen 600a (vorzugsweise gemäß Beispiel 17) in einer schematischen Seitenansicht, vorzugsweise eingerichtet gemäß einer der Ausführungsformen 100a bis 500c; und **Fig.6B** eine Detailansicht 600b dessen.

Eine exemplarische Implementierung der Außenseite 153 des Substratträger-Segments weist zwei Kupplungsaussparungen 602 auf, mittels welcher eine Kupplungsvorrichtung implementiert ist. Die Kupplungsaussparungen 602 können eingerichtet sein, einen Endeffektor, der in die Kupplungsaussparungen 602 hineingreift, aufzunehmen. Mittels des Endeffektors kann das Substratträger-Segment von einem Substratträger entfern oder diesem hinzugefügt werden, beispielsweise beim Segmenttauschen.

Eine exemplarische Implementierung des Endeffektors weist, beispielsweise pro Kupplungsaussparung des Substratträger-Segments, eine dazu komplementäre Kupplungsvorrichtung aufweisen, beispielsweise in Form eines Kupplungsschuhs, mit dem der Endeffektor in die Kupplungsaussparung hineingreift.

Eine exemplarische Implementierung (vorzugsweise gemäß) der oder jeder Kupplungsaussparung 602 ist (z.B. in die Transportrichtung 102 oder entgegen der Transportrichtung 102) abgewinkelt. Dies erleichtert es, eine (z.B. formschlüssige) Verbindung des Endeffektors, der in die Aussparungen 602 hineingreift, mit dem Substratträger-Segment zu verriegeln. Beispielsweise können mehrere Kupplungsaussparungen übereinstimmen in der Richtung, in welche diese abgewinkelt sind, was es ermöglicht das Verriegeln mittels einer Drehbewegung der Substratträger-Haltevorrichtung auszulösen.

Die abgewinkelte Kupplungsaussparung 602 kann beispielsweise in Form eines mäanderförmigen Gangs bereitgestellt sein, welcher an seinem toten Ende verdickt ist. Dies vereinfacht das Verriegeln noch weiter.

Eine exemplarische Implementierung (vorzugsweise gemäß) der oder jeder Kupplungsaussparung 602 weist einen sich zu der Montagevorrichtung hin verjüngenden Abschnitt auf, der an die Außenseite 153 angrenzt. Dies erleichtert das Einbringen des Endeffektors in die Kupplungsaussparung 602.

Eine exemplarische Implementierung (vorzugsweise gemäß) der oder jeder Kupplungsaussparung 602 weist einen mäanderförmigen Gang auf, sich zu der Montagevorrichtung hin verjüngenden Abschnitt auf, der an die Außenseite 153 angrenzt. Dies erleichtert das Einbringen des Endeffektors in die Kupplungsaussparung 602.

Wie zu den Positionsparametern erläutert, kann die Herstellung des Substratträger-Segments einen Einfluss haben auf einige Positionsparameter, darunter beispielsweise die Krümmung im unbelasteten Zustand und/oder die mechanische Steifigkeit des Substratträger-Segments. Gemäß verschiedenen Ausführungsformen werden Aspekte der Herstellung des Substratträger-Segments bereitgestellt, welche die Positionsparametervarianz reduzieren, was nachfolgend genauer erläutert wird.

Gemäß verschiedenen Ausführungsformen kann das Herstellen eines Substratträger-Segments mittels eines thermischen Prozesses erfolgen, z.B. eines thermischen Ablationsprozesses. Hierzu wird auf einen exemplarischen thermischen Prozess Bezug genommen, der mittels eines Lasers (z.B. Laserablationsprozess) erfolgt, wobei das dafür Beschriebene in Analogie für jeden andere thermischen Prozesses gelten kann. Der thermischen Prozess kann gemäß einem Prozessmuster erfolgen, für welches nachfolgend verschiedene Beispiele erläutert werden.

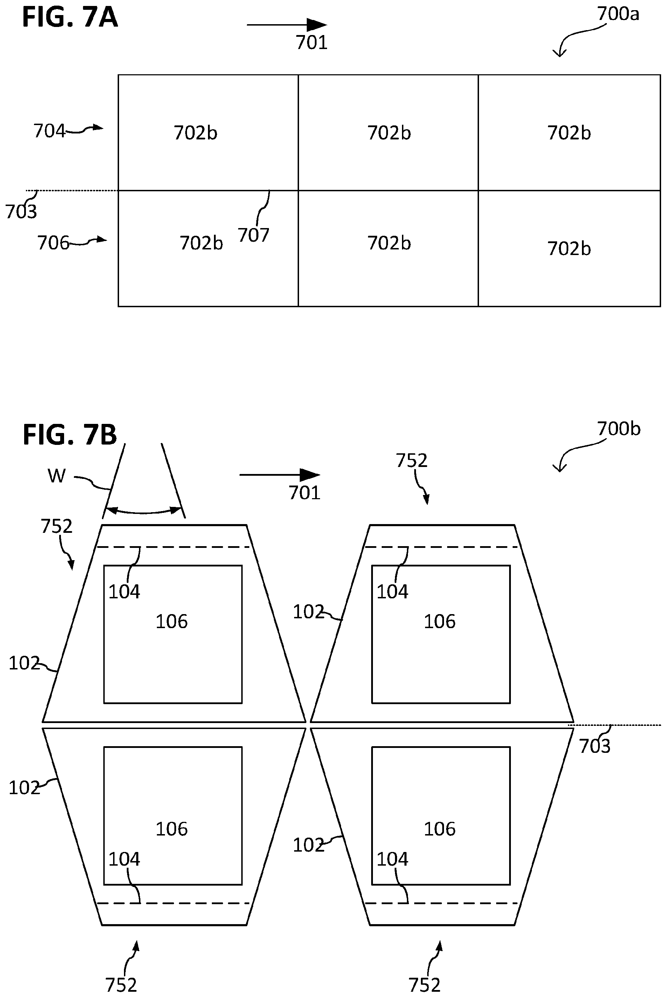

**Fig.7A** veranschaulicht ein Prozessmuster ersten Typs gemäß verschiedenen Ausführungsformen 700a (beispielsweise gemäß Beispiel 33) in einem schematischen Diagramm, gemäß dem das Herstellen mehrerer Substratträger-Segmente erfolgt, die vorzugsweise eingerichtet sind gemäß Ausführungsformen 100a bis 600b.

Eine exemplarische Implementierung des Prozessmusters ersten Typs (auch als Lagemuster bezeichnet) weist eine oder mehr als eine Reihe 704, 706 entlang einer Richtung 701 (auch als Reihenrichtung 701 bezeichnet) hintereinander angeordnete Bestrahlungsbereiche 702b (in dem Fall auch als Ablationsbereiche 702b bezeichnet) auf, wovon jeder Ablationsbereich 702b verwendet wird, um daraus ein Substratträger-Segment zu bilden. Beispielsweise kann das Lagemusters mehrere Reihen 704, 706 (auch als Mehrreihenmuster bezeichnet) aufweisen, die nebeneinander angeordnet sind. Jede Reihe kann beispielsweise eine Anzahl von R hintereinander angeordneten Ablationsbereichen 702b aufweisen, wobei R größer als 1 ist, z.B. k≥3, z.B. k≥4, z.B. k≥6, z.B. k≥8, z.B. k≥10.

Eine exemplarische Implementierung der Reihenrichtung 701 (vorzugsweise gemäß Beispiel 16) ist parallel zu einer Richtung (auch als Walzrichtung bezeichnet), in welcher eine Metallplatte gewalzt ist, aus welcher die Substratträger-Segmente hergestellt werden. Dies berücksichtigt, dass die Kristallstruktur von gewalztem Metall anisotrop ist und eine Vorzugsrichtung entlang der Walzrichtung aufweisen kann. Dies berücksichtigt ferner, dass eine Steifigkeit und/oder Verformung des Substratträger-Segments auf dieselbe Weise anisotrop sein kann. Beispielsweise kann die Metallplatte warmgewalzt werden. Dies gilt in Analogie zu den Rändern (auch als Walzrand bezeichnet) der Metallplatte, zu denen hin sich die Kristallstruktur verändern kann.

Eine exemplarische Implementierung des Mehrreihenmusters weist genau zwei Reihen auf, die an einer Achse 703 aneinandergrenzen und/oder symmetrisch zu der Achse 703 eingerichtet sind, Die Achse 703 ist vorzugsweise entlang der Reihenrichtung 701, der Walzrichtung und/oder dem Walzrand sein. Beispielsweise können die Ablationsbereiche 702b symmetrisch zu der Achse 703 eingerichtet und ausgerichtet sein.

Eine exemplarische Implementierung jedes Ablationsbereiches 702 weist eine (z.B. digitale) Repräsentanz (auch als Geometrierepräsentanz bezeichnet) des herzustellenden Substratträger-Segments auf, z.B. der Geometrie des herzustellenden Substratträger-Segments und/oder einer oder mehr als einer Kontur des herzustellenden Substratträger-Segments. Das Lagemuster kann somit, pro Ablationsbereich 702, eine Geometrierepräsentanz aufweisen. Die Geometrierepräsentanz kann beispielsweise als Trajektorie angegeben werden, entlang welcher der Laserstrahl geführt wird.

Eine exemplarische Implementierung der Geometrierepräsentanz ist symmetrisch zu der Reihenrichtung 701, der Achse 703, der Walzrichtung und/oder dem Walzrand ausgerichtet. Im Fall des Mehrreihenmusters können die Geometrierepräsentanzen symmetrisch zu der Achse 703 ausgerichtet sein.

Eine exemplarische Implementierung des
Laserablationsprozesses weist auf, die Metallplatte gemäß dem Lagemuster mittels des Lasers zu bestrahlen, z.B. gemäß jeder Geometrierepräsentanz des Lagemusters. Dabei kann jeder der Ablationsbereiche 702 mittels des Lasers zerteilt werden (dann auch als Laserteilungsprozess bezeichnet) in mehrere Teile, wovon ein Teil gemäß der Geometrierepräsentanz eingerichtet ist und zu einem Substratträger-Segment verarbeitet wird.

**Fig.7B** veranschaulicht ein Lagemuster gemäß verschiedenen Ausführungsformen 700b in einem schematischen Diagramm, gemäß dem das Herstellen mehrerer Substratträger-Segmente erfolgt, die vorzugsweise eingerichtet sind gemäß Ausführungsformen, wobei zum vereinfachten Verständnis jede der Geometrierepräsentanzen 752 mit den Bezugszeichen der herzustellenden Substratträger-Segmente versehen ist.

Eine exemplarische Implementierung des Mehrreihenmusters weist mehrere Paare von Ablationsbereichen 702b auf, welche entlang der Reihenrichtung hintereinander angeordnet sind und/oder wovon jedes Paar zwei Geometrierepräsentanzen aufweist, welche symmetrisch angeordnet sind zu der Achse 703 (dann auch als Symmetrieachse bezeichnet) des Lagemusters. Beispielsweise können die Geometrierepräsentanzen mit ihrer Außenseite 153 einander zugewandt sein.

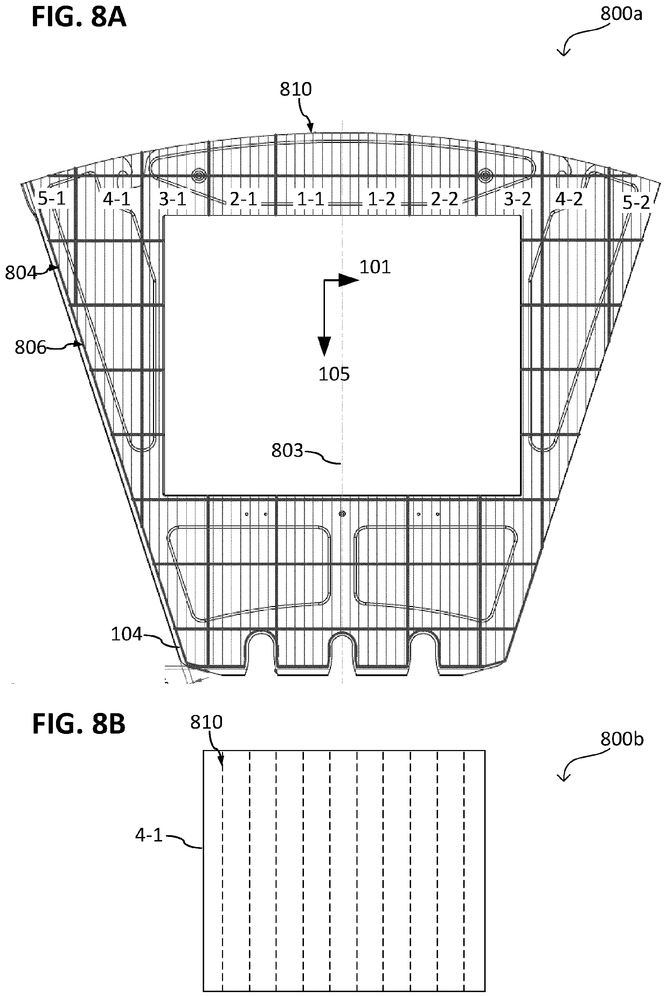

**Fig.8A** veranschaulicht ein Prozessmuster zweiten Typs gemäß verschiedenen Ausführungsformen 800a (beispielsweise gemäß Beispiel 33) in einem schematischen Diagramm, gemäß dem das Herstellen mehrerer Substratträger-Segmente erfolgt, die vorzugsweise eingerichtet sind gemäß Ausführungsformen 100a bis 700b; und **Fig.8B** eine Detailansicht 800b eines Modifikationsbereichs.

Eine exemplarische Implementierung eines Verfahrens, das basierend auf dem Prozessmusters zweiten Typs (auch als Modifikationsmuster bezeichnet) erfolgt, weist auf, ein Resultat des Laserteilungsprozesses (z.B. das Substratträger-Segments in einer Vorstufe dessen) mittels des Lasers gemäß dem Modifikationsmuster zu bestrahlen. Das Bestahlen mittels des Lasers gemäß dem Modifikationsmuster kann eingerichtet sein, die Oberfläche des Resultat des Laserteilungsprozesses zu verändern, z.B. dessen Rauheit (dann auch als Rauhlasern bezeichnet) und/oder Haftvermittlung zu vergrößern. Das Rauhlasern begünstigt anschaulich die Haftung einer Beschichtung an dem Substratträger-Segment, was die Häufigkeit des Reinigens des Substratträger-Segment verringert.

Eine exemplarische Implementierung des Rauhlasern ist eingerichtet, die Rauheit zu vergrößern, beispielsweise um einen Faktor 10^{r}, wobei r≥0 ist, z.B. r≥1, z.B. r≥2.

Eine exemplarische Implementierung des Modifikationsmusters implementiert eine zeitliche Sequenz (auch als Modifikationssequenz bezeichnet) und/oder weist mehrere Paare von Bestrahlungsbereichen (in dem Fall auch als Modifikationsbereiche bezeichnet) auf, welche hierin mittels eines Tupels (x-y) indiziert werden, wobei x das Paar referenziert und y die Reihenfolge referenziert, in denen die zwei Modifikationsbereiche des Paars bestrahlt werden. Beispielsweise kann das Modifikationsmuster eine oder mehr als eine Reihe 804, 806 entlang der Transportrichtung 101 (dann auch als Reihenrichtung 101 bezeichnet) hintereinander angeordnete Modifikationsbereiche aufweisen, wovon jede Reihe mehrere Paare von Modifikationsbereichen aufweist. Jede Reihe kann beispielsweise eine Anzahl von R hintereinander angeordneten Modifikationsbereichen aufweisen, wobei R größer als 1 ist, z.B. k≥3, z.B. k≥4, z.B. k≥6, z.B. k≥8, z.B. k≥10.

Eine exemplarische Implementierung jedes Paars x von Modifikationsbereichen weist zwei Modifikationsbereiche x-1 und x-2 auf, welche symmetrisch eingerichtet (z.B. angeordnet) sind zu einer Achse 803. Dies Achse 803 kann beispielsweise parallel sein zu der Radialrichtung 105, quer sein zu der Transportrichtung 101 und/oder die Winkelhalbierende des Seitenwinkels W sein.

Eine exemplarische Implementierung der Modifikationssequenz weist eine oder mehr als eine zeitliche Reihenfolge auf, gemäß welcher das Bestrahlen erfolgt, z.B. eine erste und eine zweite zeitliche Reihenfolge. Die erste zeitliche Reihenfolge ist auf den Index x bezogen und bewirkt, dass die Paare gemäß ihrem Indes x nacheinander abgearbeitet werden. Die erste zeitliche Reihenfolge ist, für jedes Paar von Modifikationsbereichen, auf den Index y des Paars bezogen und bewirkt, dass die Modifikationsbereiche des Paares gemäß ihrem Indes y nacheinander abgearbeitet werden. Beispielsweise werden die Modifikationsbereiche in folgender Reihenfolge nacheinander abgearbeitet: 1-1, 1-2, 2-1, 2-2, 3-1, 3-2, 4-1, 4-2, 5-1, 5-2, usw. Dies bewirkt eine möglichst symmetrische Prozessierung des Substratträger-Segments.

Eine exemplarische Implementierung jedes Modifikationsbereichs (siehe auch Detailansicht 800b) implementiert eine oder mehr als eine Trajektorie 810, entlang welcher das Bestrahlen erfolgt. Die Trajektorie 810 kann beispielsweise mehrere nebeneinander und/oder linear verlaufende Abschnitte aufweisen oder zumindest mehrere Reihen von hintereinander angeordneten Bestrahlungspositionen, auf welche der Laserstrahl gerichtet wird.

Eine exemplarische Implementierung der Trajektorie 810 weist einen oder mehr als einen Abschnitt auf, welcher linear entlang der Achse 803 und/oder der Radialrichtung 105 verläuft. Dies verbessert die Symmetrie der Bearbeitung und reduziert damit die Verformung.

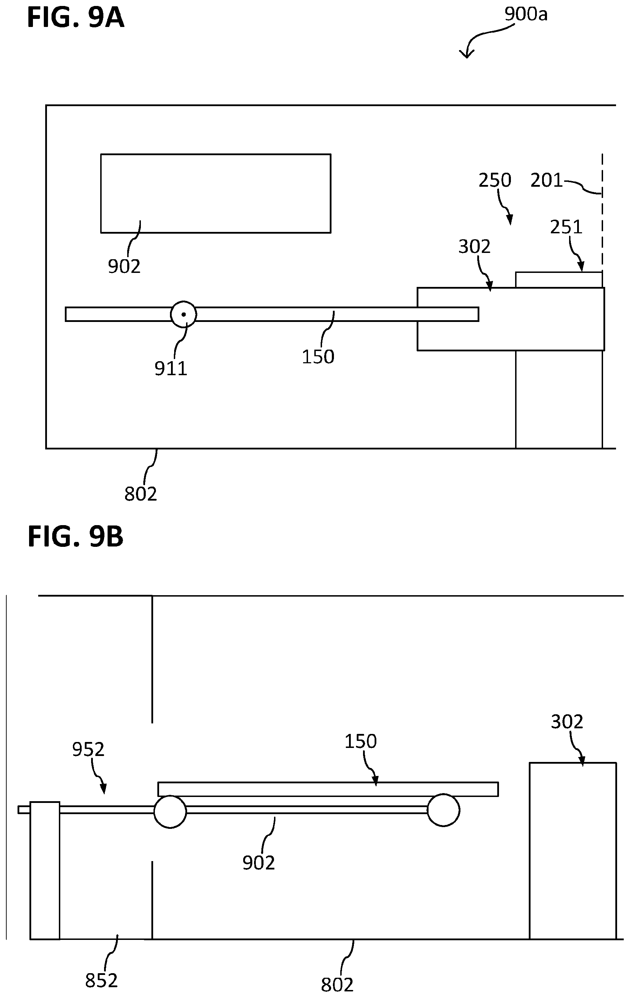

**Fig.9A** veranschaulicht eine Vakuumanordnung gemäß verschiedenen Ausführungsformen 900a (beispielsweise gemäß Beispiel 27) in einer schematischen Querschnittsansicht, in welcher die Substratträger-Haltevorrichtung und der Substratträger angeordnet sind, die vorzugsweise eingerichtet sind gemäß Ausführungsformen 100a bis 800b. Eine exemplarische Implementierung der Vakuumanordnung (vorzugsweise gemäß Beispiel 28) weist eine oder mehr als eine Beschichtungsvorrichtung 902 in der Vakuumkammer 802 auf, welche eingerichtet ist, ein Beschichtungsmaterial zu emittieren, zu dem Transportpfad 911, entlang dem die Substratträger-Segmente 150 des Substratträgers transportiert werden.

**Fig.9B** veranschaulicht eine Vakuumanordnung gemäß verschiedenen Ausführungsformen 900b (beispielsweise gemäß Beispiel 27) in einer schematischen Querschnittsansicht, in welcher die Substratträger-Haltevorrichtung und der Substratträger angeordnet sind, die vorzugsweise eingerichtet sind gemäß Ausführungsformen 100a bis 900a. Eine exemplarische Implementierung der Vakuumanordnung weist eine Segment-Transportvorrichtung 952 auf, welche eingerichtet ist, ein Substratträger-Segment 150 zu der Substratträger-Haltevorrichtung 250 hin oder davon weg zu transportieren. Beispielsweise kann das Segmenttauschen mittels der Segment-Transportvorrichtung 952 erfolgen. Die Segment-Transportvorrichtung 952 kann beispielsweise in einer zusätzlichen Vakuumkammer 852 angeordnet sein, welche neben der Vakuumkammer 802 angeordnet ist.

Im Folgenden werden verschiedene Arbeitsbeispiele beschrieben, die sich auf vorangehend Beschriebene und in den Figuren Dargestellte beziehen.

Ein exemplarisches Arbeitsbeispiel 1 weist eine Vakuumanordnung auf, die als Drehtellerbeschichtungsanlage eingerichtet ist.

Ein exemplarisches Arbeitsbeispiel 2 stellt einen mehrteiligen Drehtellers bereit, der einen Satz aus mehreren kreisringsegment-förmigen Substratträger-Segmenten (beispielsweise in Form von Tortenstücken) aufweist. Ferner wird eine Nabe zur Aufnahme der Substratträger-Segmente bereitgestellt.

Ein exemplarisches Arbeitsbeispiel 3 vergrößert die Präzision hinsichtlich der Position des Substratträgers relativ zur Beschichtungsquelle und/oder mindert Kosten und Aufwand.

Ein exemplarisches Arbeitsbeispiel 4 erleichtert die Montage jedes Substratträger-Segments. Die Substratträger-Haltevorrichtung weist eine Nabe und daran befestigt, pro Substratträger-Segment, eine Spannbacke zum Montieren und Ausrichten des Substratträger-Segments auf. Die Spannbacke kann beispielsweise drehbar gelagert sein, beispielsweise mittels eines Drehgelenks, das eine Welle aufweist. Das Drehgelenk erleichtert es, den Substratträger zu kippen und/oder anzuheben, oder allgemeiner gesprochen, auszurichten. Ferner können zusätzliche Schrauben vorhanden sein, um resultierende Position des Drehgelenks zu arretieren.

Ein exemplarisches Arbeitsbeispiel 5 weist zwei Spannbacken auf, zwischen denen eine Führung des Substratträger-Segments mittels Kugellager bereitgestellt ist. Ferner sind zwischen den Spannbacken mehrere Federn, welche die Spannbacken auseinanderdrücken. Das Substratträger-Segment, z.B. dessen Montagevorrichtung, weist zu den Kugellagern komplementäre Aussparungen auf, in welche Kugellager und/oder eine Spannschraube hineingreifen.

Ein exemplarisches Arbeitsbeispiel 6 stellt bereit, dass die Spannbacken und das Substratträger-Segment vertikal ineinandergreifen, was die Bewegung des Substratträger-Segments relativ zu den Spannbacken hemmt und eine Zentrierung begünstigt. Beispielsweise können diese formschlüssig ineinandergreifen. Runde Konturen begünstigen es, eine potentielle Fehlstellung korrigieren zu können.

Ein exemplarisches Arbeitsbeispiel 7 stellt eine verbesserte Geometrie des Substratträger-Segments bereit, welche ein gewinkeltes Langloch als Kupplungsaufnahme aufweist, in welche der Handler greifen kann. Mittels Drehen des Drehtellers lässt sich eine formschlüssige Kupplung zwischen Substratträger-Segment und Handler herstellen oder lösen. Zwei Langlöcher pro Substratträger-Segment können, jedes, in dieselbe Richtung abgewinkelt sein.

Ein exemplarisches Arbeitsbeispiel 8 stellt eine Nut-Zapfen-Verbindung zwischen einander unmittelbar benachbarten Substratträger-Segmenten des Substratträgers bereit. Ein keilförmiger Vorsprung begünstigt die Zentrierung der einander unmittelbar benachbarten Substratträger-Segmente. Ein zusätzlicher Zapfen (z.B. eine Nase) am keilförmigen Vorsprung, am äußeren Umfang des Substratträgers angeordnet, ermöglicht es, die Substratträger-Segment zu nivellieren, indem der Vorsprung in Aussparung eingreift. Die Nut-Zapfen-Verbindung kann beispielsweise nur eine außenliegende Verbindung herstellen, so dass die Position des Substratträger-Segments mittels des ersten Stellglieds leichter variiert werden kann.

Ein exemplarisches Arbeitsbeispiel 9 stellt eine symmetrische Bearbeitung des Substratträger-Segments bereit, was eine nachträgliche Verformung des Carriers aufgrund von mechanischer Spannung hemmt.

Ein exemplarisches Arbeitsbeispiel 10 stellt eine Substrathaltevorrichtung bereit, die mehrere Substrat aufnehmen kann, z.B. einen Stapel mehrerer Substrate. Dazu kann die Substrathaltevorrichtung beispielsweise einen (z.B. rahmenförmigen) Abstandshalter (auch als Spacer bezeichnet) aufweisen, der zwischen zwei Substraten des Stapels angeordnet ist.

Ein exemplarisches Arbeitsbeispiel 11 stellt mehrere Substratträger bereit, wovon jeder Substratträger mehre Substratträger-Segmente aufweist, welche zusammengefügt den Substratträger bilden, und wovon sich zumindest zwei Substratträger voneinander unterscheiden, beispielsweise in einer Geometrie der Substratträger-Segmente und/oder der Substrathaltevorrichtung (z.B. Größe, Form, Typ).

Ein exemplarisches Arbeitsbeispiel 12 stellt eine verbesserte Herstellung des Substratträger-Segments bereit. Dazu kann der Substratträger-Segment mittels Rauhlaserns aufgeraut werden, wobei das Rauhlasern gemäß einem Muster (z.B. von Bearbeitungsbereichen) erfolgt, welche symmetrisch sind zu einer Soll-Krümmung des Carriers, die zurückbleibt nach Rauhlasern. Alternativ oder zusätzlich kann das Auslasern mehrerer Substratträger-Segment aus Platte erfolgen, deren Randbereiche (anschaulich den Walzrand aufweisend) stehen bleiben. Die Randbereiche weisen ein anderes Gefüge auf als der Rest der Platte. Das Auslasern kann symmetrisch zur Walzrichtung erfolgen.

Ein exemplarisches Arbeitsbeispiel 13 stellt eine Symmetrieachse bereit, zu welcher das Prozessmuster symmetrisch ist, wobei die Symmetrieachse durch eine Schwerpunkt, z.B. Masseschwerpunkt und/oder geometrischen Schwerpunkt, hindurch verläuft.

Ein exemplarisches Arbeitsbeispiel 14 stellt eine Symmetrieachse der Substratauflagefläche bereit, zu welcher das Prozessmuster symmetrisch ist.

## Patentansprüche

1. Substratträger-Segment (150), aufweisend:
• ein Trägergestell (102),
• eine Substrathaltevorrichtung (106) zum Halten eines Substrats, welche zumindest teilweise in das Trägergestell (102) integriert oder daran montiert ist;
• eine an das Trägergestell (102) angrenzende Montagevorrichtung (104) zum Montieren des Substratträger-Segments, zu welcher hin sich das Trägergestell (102) verjüngt;
• zwei zueinander komplementär eingerichtete Formschlusskonturen (502a, 502b), zwischen denen eine der Montagevorrichtung (104) gegenüberliegende Außenseite (153) des Trägergestells (102) angeordnet ist.

2. Substratträger-Segment (150) gemäß Anspruch 1, wobei die Substrathaltevorrichtung (106) zwischen der Außenseite (153) und der Montagevorrichtung (104) angeordnet ist.

3. Substratträger-Segment (150) gemäß einem der Ansprüche 1 bis 2, wobei die zwei Formschlusskonturen (502a, 502b) zum Zentrieren mittels Ineinandergreifens eingerichtet sind.

4. Substratträger-Segment (150) gemäß einem der Ansprüche 1 bis 3, wobei eine der Formschlusskonturen (502a, 502b) zumindest abschnittsweise keilförmig ist.

5. Substratträger-Segment (150) gemäß Anspruch 4, wobei die Formschlusskontur eine zapfenförmige Steckvorrichtung aufweist.

6. Substratträger-Segment (150) gemäß einem der Ansprüche 1 bis 5, ferner aufweisend:
eine Symmetrieachse (803), zu welcher ein Bearbeitungsmuster, gemäß welchem das Substratträger-Segment aufgeraut ist, symmetrisch ist und zu welcher eine Walzrichtung des Substratträger-Segment quer verläuft.

7. Substratträger-Segment (150) gemäß einem der Ansprüche 1 bis 6, ferner aufweisend:
• eine abgewinkelte Aussparung (602) an der Außenseite (153), welche sich zu der Montagevorrichtung (104) hin erstreckt.

8. Substratträger-Haltevorrichtung (250), aufweisend:
• eine Drehachse (201),
• mehrere, gemäß einem Muster um die Drehachse (201) herum angeordnete Montagesockel (204),
wovon jeder Montagesockel (204) aufweist:
• eine Aufnahmevorrichtung (302) zum Aufnehmen eines Substratträger-Segments (150);
• ein Drehgelenk (402), mittels dessen die Aufnahmevorrichtung beweglich gelagert ist;
• ein erstes Stellglied, welches eingerichtet ist zum Verändern eines Winkels zwischen der Drehachse (201) und der Aufnahmevorrichtung (302).

9. Substratträger-Haltevorrichtung gemäß Anspruch 8, wobei die Aufnahmevorrichtung (302) zwei relativ zueinander beweglich gelagerte Spannbacken (354a, 354b) aufweist, zwischen denen ein Aufnahmespalt gebildet ist.

10. Vakuumanordnung gemäß Anspruch 9, wobei der Montagesockel (104) ein zweites Stellglied aufweist zum Übertragen einer Kraft auf die Spannbacken.

11. Verwenden eines thermischen Bestrahlungsprozesses zum Bilden eines Substratträger-Segments (150), welcher gemäß einem Prozessmuster durchgeführt wird, das symmetrisch ist zu einer Symmetrieachse des Substratträger-Segments (150).

12. Verwenden gemäß Anspruch 11, wobei der thermische Bestrahlungsprozesses mittels eines Lasers erfolgt.

13. Verwenden gemäß Anspruch 11 oder 12, wobei das Prozessmuster mehrere Paare von Bestrahlungsbereichen implementiert, wobei die Bestrahlungsbereiche eines Paars symmetrisch zu der Symmetrieachse und unmittelbar nacheinander dem Bestrahlungsprozess ausgesetzt werden.

14. Verwenden gemäß einem der Ansprüche 11 bis 13, wobei das Prozessmuster symmetrisch ist:
• zu einer Walzrichtung des Substratträger-Segment (150) oder zumindest eines Halbzeugs, aus welchem das Substratträger-Segment (150) gebildet wird; und/oder
• zu einem Walzrand des Substratträger-Segment (150) oder zumindest des Halbzeugs.

15. Verfahren, aufweisend:
• Ansteuern eines thermischen Bestrahlungsprozesses gemäß einem Prozessmuster;
• Bilden eines Substratträger-Segments (150) mittels des Bestrahlungsprozesses, wobei das Prozessmuster symmetrisch ist zu einer Symmetrieachse des Substratträger-Segments (150).
